(19) Europäisches Patentamt
European Patent Office
Office européen des brevets

(11) EP 1 939 686 B1

(12) **EUROPEAN PATENT SPECIFICATION**

(45) Date of publication and mention of the grant of the patent:
**17.11.2010 Bulletin 2010/46**

(51) Int Cl.:
*G03F 7/00* (2006.01) *G03H 1/02* (2006.01)
*G03F 7/033* (2006.01)

(21) Application number: **07017469.3**

(22) Date of filing: **06.09.2007**

(54) **Holographic recording medium**

Holographisches Aufzeichnungsmedium

Support d'enregistrement holographique

(84) Designated Contracting States:
**DE FR GB**

(30) Priority: **18.12.2006 JP 2006340199**

(43) Date of publication of application:
**02.07.2008 Bulletin 2008/27**

(73) Proprietor: **Kabushiki Kaisha Toshiba**
**Minato-ku,**
**Tokyo 105-8001 (JP)**

(72) Inventors:
- **Mikoshiba, Satoshi**
**Minato-ku**
**Tokyo 105-8001 (JP)**
- **Hirao, Akiko**
**Minato-ku**
**Tokyo 105-8001 (JP)**
- **Hayase, Rumiko**
**Minato-ku**
**Tokyo 105-8001 (JP)**
- **Matsumoto, Kazuki**
**Minato-ku**
**Tokyo 105-8001 (JP)**
- **Sasao, Norikatsu**
**Minato-ku**
**Tokyo 105-8001 (JP)**
- **Kamikawa, Takahiro**
**Minato-ku**
**Tokyo 105-8001 (JP)**

(74) Representative: **HOFFMANN EITLE**
**Patent- und Rechtsanwälte**
**Arabellastrasse 4**
**81925 München (DE)**

(56) References cited:
**EP-A- 1 550 677** **US-A1- 2005 196 679**
**US-A1- 2006 115 740**

- **HAYASE S ET AL: "POLYMERIZATION OF CYCLOHEXENE OXIDE WITH AL(ACAC)3-SILANOL CATALYST" JOURNAL OF POLYMER SCIENCE, POLYMER CHEMISTRY EDITION, INTERSCIENCE POUBLISHERS, NEW YORK, NY, US, vol. 19, no. 9, 1 September 1981 (1981-09-01), pages 2185-2194, XP000567733 ISSN: 0360-6376**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 939 686 B1

## Description

This invention relates to a holographic recording medium and to a method for manufacturing the holographic recording medium.

A holographic memory which records information as a hologram is now attracting many attentions as a recording medium of the next generation since it capable of performing a large capacity of recording. As the photosensitive composition for the holographic recording, it is known to employ a composition comprising, as main components, a radical polymerizable monomer, a thermoplastic binder resin, a photo-radical polymerization initiator and a sensitizing dye. This photosensitive composition for the holographic recording is molded into a film to form a recording layer. Information is recorded in this recording layer through interference exposure.

When the recording layer has been subjected to the interference exposure, the regions thereof which are strongly irradiated with light are permitted to undergo the polymerization reaction of the radical polymerizable monomer. The radical polymerizable monomer diffuses from the regions where the intensity of exposure beam irradiated is weak to the regions where the intensity of exposure beam irradiated is strong, thereby generating the gradient of concentration in the recording layer. Namely, depending on the magnitude in intensity of the interference beam, differences in density of the radical polymerizable monomer occur, thereby generating a difference in refractive index in the recording layer.

A recording medium comprising a three-dimensional cross-linking polymer matrix, and a radical polymerizable monomer dispersed in the matrix has been recently proposed. In order to make the medium effective as a recording layer, the matrix having a radical polymerizable monomer dispersed therein is required to have some degree of hardness. However, if the hardness of the matrix is too high, it may become impossible to enable the radical polymerizable monomer sufficiently to move, thus making it impossible to bring about a sufficient difference in refractive index. Because of these reasons, the holographic recording medium to be obtained in this case is limited in recording capacity and in the modulation of refractive index. Further, due to the polymerization of the radical polymerizable monomer, the recording layer sometimes locally shrinks. In that case, it may become impossible to accurately regenerate the data that have been recorded therein.

A holographic recording medium according to one aspect of the present invention comprises a recording layer containing a three-dimensional cross-linking polymer matrix, a radical polymerizable compound, and a photo-radical polymerization initiator, characterized in that the three-dimensional cross-linking polymer matrix is represented by the following general formula (1):

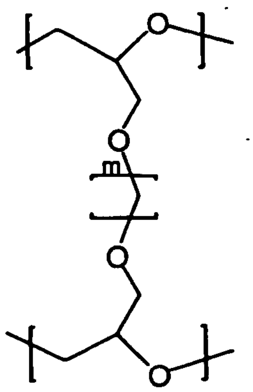

(1)

wherein m is an integer ranging from 3 to 16.

US 2006/0115740 describes a hologram recording medium having the features of the holographic recording medium as recited in the preamble of the appending claim 1.

A method of manufacturing a holographic recording medium according to one aspect of the present invention comprises mixing an epoxy monomer, a hydrocarbon substituted silanol, a metal complex, a photo-radical polymerization initiator, and a radical polymerizable compound to obtain a raw material solution for a recording layer; coating the raw material solution on a light-transmitting substrate or interposing the raw material solution between a pair of facing light-transmitting substrates to form a resin layer; and heating the resin layer at a temperature within a range of 10°C to less than 80°C to polymerize the epoxy monomer, thereby forming a recording layer comprising a three-dimensional cross-linking polymer matrix represented by the following general formula (1):

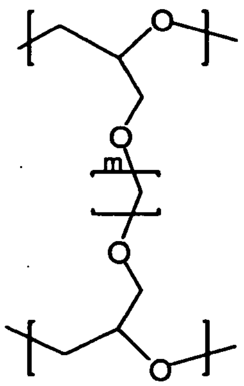

(1)

wherein m is an integer ranging from 3 to 16.

The invention can be more fully understood from the following detailed description when taken in conjunction with the accompanying drawings, in which:

FIG. 1 is a cross-sectional view schematically illustrating the transmission type holographic recording medium according to one embodiment;
FIG. 2 is a diagram schematically illustrating the transmission type holographic information recording/regenerating apparatus;
FIG. 3 is a cross-sectional view schematically illustrating the reflection type holographic recording medium according to another embodiment;
FIG. 4 is a diagram schematically illustrating the reflection type holographic information recording/regenerating apparatus; and
FIG. 5 is a graph illustrating one example of holographic angular multiple regenerating signal according to one embodiment.

Next, the embodiments of the present invention will be explained.

The recording layer of the holographic recording medium according to one embodiment comprises a specific kind of three-dimensional cross-linking polymer matrix, a radical polymerizable compound, and a photo-radical polymerization initiator. In this case, the radical polymerizable compound and the photo-radical polymerization initiator are dispersed in the three-dimensional cross-linking polymer matrix. When a beam of light is irradiated to a predetermined region of the recording layer, the radical polymerizable compound is caused to move from an unexposed region to the exposed region, thereby enabling the radical polymerizable compound existing in the exposed region to polymerize due to the effects of the photo-radical polymerization initiator. By this mechanism, the recording of information is performed. Since the radical polymerizable compound is required to be moved inside the three-dimensional cross-linking polymer matrix, the three-dimensional cross-linking polymer matrix is required to be constructed so as not to prevent the moving of the radical polymerizable compound. It has been found out by the present inventors that the chemical structure represented by the following general formula (1) is optimal in characteristics for use as a three-dimensional cross-linking polymer matrix of the recording layer of the holographic recording medium.

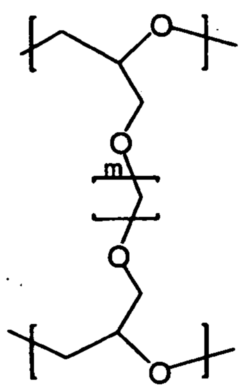

(1)

wherein m is an integer ranging from 3 to 16.

In the three-dimensional cross-linking polymer matrix represented by the aforementioned general formula (1), a substituent group having a high polarity such as an amino group and amide is not existed in the skeleton of the polymer matrix. Because of this, the radical polymerizable monomer which moves inside the three-dimensional cross-linking polymer matrix is enabled to freely move without being influenced by the polarity of the polymer matrix.

Moreover, this three-dimensional cross-linking polymer matrix is constituted by alkyl group and an ethylene oxide skeleton. Since the skeleton constructed in this manner is flexible, this polymer matrix itself is enabled to move flexibly as the radical polymerizable compound moves. For this reason, the moving of the radical polymerizable compound inside the three-dimensional cross-linking polymer matrix can be further promoted. When the m in the aforementioned general formula (1) is confined within the range of 6 to 12, it is possible to expect more preferable effects of the three-dimensional cross-linking polymer matrix. Further, when the m in the aforementioned general formula (1) is confined within the range of 8 to 12, it is possible to expect most preferable effects of the three-dimensional cross-linking polymer matrix.

It is preferable that an aromatic ring is not included in the three-dimensional cross-linking polymer matrix represented by the aforementioned general formula (1). If an aromatic ring is included in the polymer matrix, the flexibility of the skeleton would be degraded, thereby possibly obstructing the movement of the radical polymerizable compound. Furthermore, the polarity of the polymer matrix changes to enhance the affinity the polymer matrix with the radical polymerizable compound, thus obstructing the movement of the radical polymerizable compound.

Further, in order to obviate the problems including the absorption of light by the aromatic ring, the reduction of voids of the polymer matrix due to the orientation of the aromatic ring, and the increase of the refractive index of the polymer matrix, it is desired that the aromatic ring does not exist in the skeleton of the polymer matrix.

The structure of the three-dimensional cross-linking polymer matrix constituting the recording layer of the holographic recording medium according to one embodiment can be confirmed by, for example, pyrolizer GC-MS, FT-IR or near infrared FT-IR.

The three-dimensional cross-linking polymer matrix represented by the aforementioned general formula (1) can be synthesized through the cationic polymerization of epoxy monomer. As the epoxy monomer, it is possible to employ, for example, glycidyl ether. More specifically, examples of the epoxy monomer include ethylene glycol diglycidyl ether, 1,4-butanediol diglycidyl ether, 1,5-pentanediol diglycidyl ether, 1,6-hexanediol diglycidyl ether, 1,8-octanediol diglycidyl ether, 1,10-decanediol diglycidyl ether, 1,12-dodecanediol diglycidyl ether, etc.

When the easiness of moving of the radical polymerizable compound in the polymer matrix is taken into consideration, the epoxy monomer should preferably be selected from the compounds represented by the following general formula (9).

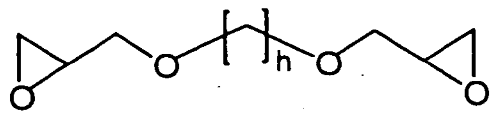

(9)

(in the general formula (9), h is an integer ranging from 8 to 12)

Examples of the compounds represented by the general formula (9) include 1,8-octanediol diglycidyl ether, 1,10-decanediol diglycidyl ether, and 1,12-dodecanediol diglycidyl ether.

The cationic polymerization of the epoxy monomer can be carried out using a metal complex and hydrocarbon substituted silanol both acting as a catalyst.

As for the metal complex, it is possible to employ the compounds represented by the following general formulas (4), (5) and (6) :

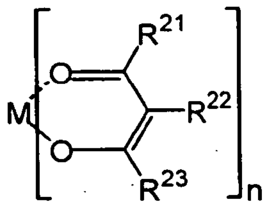
(4)

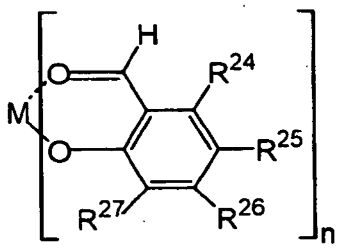
(5)

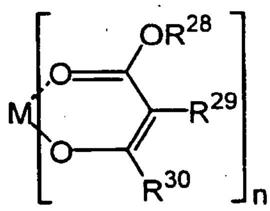
(6)

(in the general formulas (4), (5) and (6), M is selected from the group consisting of Al, Ti, Cr, Mn, Fe, Co, Ni, Cu, Zr, Zn, Ba, Ca, Ce, Pb, Mg, Sn and V; $R^{21}$, $R^{22}$ and $R^{23}$ may be the same or different and are individually hydrogen atom, substituted or unsubstituted alkyl group having 1 to 10 carbon atoms; $R^{24}$, $R^{25}$, $R^{26}$ and $R^{27}$ may be the same or different and are individually hydrogen atom, substituted or unsubstituted alkyl group having 1 to 10 carbon atoms; $R^{28}$, $R^{29}$ and $R^{30}$ may be the same or different and are individually hydrogen atom, substituted or unsubstituted alkyl group having 1 to 10 carbon atoms; and n is an integer of 2 to 4)

When the compatibility of the metal complex with the three-dimensional cross-linking polymer matrix and the catalytic capacity thereof are taken into consideration, the M in these general formulas (4), (5) and (6) should preferably be selected from aluminum (Al) and zirconium (Zr), and $R^{21}$-$R^{30}$ should preferably be selected from alkyl acetate such as acetyl acetone, methylacetyl acetate, ethylacetyl acetate, propylacetyl acetate, etc. Among them, the most preferable metal complex is aluminum tris(ethylacetyl acetate).

As the hydrocarbon substituted silanol, it is possible to employ compounds represented by the following general formula (2).

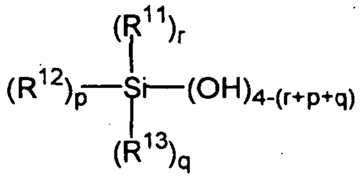
(2)

(in the general formula (2), $R^{11}$, $R^{12}$ and $R^{13}$ may be the same or different and are individually substituted or unsubstituted alkyl group having 1 to 30 carbon atoms, substituted or unsubstituted aromatic group having 6 to 30 carbon atoms, or substituted or unsubstituted aromatic heterocyclic group having 3 to 30 carbon atoms; and p, q and r are individually an integer of 0 to 3 with a proviso that p+q+r is 3 or less)

As examples of the alkyl group to be introduced as $R^{11}$, $R^{12}$ and $R^{13}$ into the general formula (2), they include, for example, methyl, ethyl, propyl, butyl, pentyl, hexyl, etc. As examples of the aromatic group to be introduced as $R^{11}$, $R^{12}$ and $R^{13}$ into the general formula (2), they include, for example, phenyl, naphthyl, tolyl, xylyl, cumenyl, mesityl, etc. As examples of the aromatic heterocyclic group to be introduced as $R^{11}$, $R^{12}$ and $R^{13}$ into the general formula (2), they include, for example, pyridyl, quinolyl, etc. At least one of the hydrogen atoms in these alkyl group, aromatic group and aromatic heterocyclic group may be substituted by a substituent group such as halogen atoms, etc.

Specific examples of hydrocarbon substituted silanol include diphenyl disilanol, triphenyl silanol, trimethyl silanol, triethyl silanol, diphenyl silanediol, dimethyl silanediol, diethyl silanediol, phenyl silanediol, methyl silanetriol, ethyl silanetriol, etc. When the compatibility of hydrocarbon substituted silanol with the three-dimensional cross-linking polymer matrix and the catalytic capacity thereof are taken into consideration, the employment of diphenyl disilanol or triphenyl silanol is preferable as the hydrocarbon substituted silanol.

The phenolic compound represented by the following general formula (3) can be employed as a compound having almost the same effects as the hydrocarbon substituted silanol represented by the aforementioned general formula (2).

$R^{14}$-Ar-OH (3)

(in the general formula (3), $R^{14}$ is substituted or unsubstituted alkyl group having 1 to 30 carbon atoms, or substituted aromatic group having 6 to 30 carbon atoms; and Ar is substituted or unsubstituted aromatic group having 3 to 30 carbon atoms)

As examples of the alkyl group to be introduced as $R^{14}$ into the general formula (3), they include, for example, methyl, ethyl, propyl, butyl, pentyl, hexyl, trifluoromethyl, pentafluoroethyl, etc. At least one of the hydrogen atoms in the alkyl group may be substituted by a substituent group such as a halogen atom, etc.

As examples of the substituted aromatic group that can be introduced as $R^{14}$ into the general formula (3), they include, for example, $HO(C_6H_6)SO_2$-, $HO(C_6H_6)C(CH_3)_2$-, $HO(C_6H_6)CH_2$-, etc.

As examples of the aromatic group that can be introduced as Ar into the general formula (3), they include, for example, phenyl, naphthyl, tolyl, xylyl, cumenyl, mesityl, etc. At least one of the hydrogen atoms in the aromatic group may be substituted by the aforementioned substituent group.

Since the phenolic compound represented by the aforementioned general formula (3) is capable of executing a substitution reaction with the ligand of the metal complex, the phenolic compound is enabled to exhibit almost the same effects as the hydrocarbon substituted silanol represented by the aforementioned general formula (2).

As examples of the phenolic compound represented by the aforementioned general formula (3), they include $HO(C_6H_6)SO_2(C_6H_6)OH$, $HO(C_6H_6)CH_2(C_6H_6)OH$, $HO(C_6H_6)C(CH_3)_2(C_6H_6)OH$, $CF_3(C_6H_6)OH$, $CF_3CF_2(C_6H_6)OH$, etc. When the compatibility of phenolic compound with the three-dimensional cross-linking polymer matrix and the catalytic capacity thereof are taken into consideration, the employment of $CF_3(C_6H_6)OH$ or $HO(C_6H_6)SO_2(C_6H_6)OH$ is preferable as the phenolic compound.

A cationic polymerization catalyst which is composed of a combination of the hydrocarbon substituted silanol represented by the aforementioned general formula (2) with the metal complex represented by any one of the aforementioned general formulas (4), (5) and (6) is capable of promoting the polymerization reaction of the radical polymerizable compound at room temperature (25°C). Therefore, it is possible to form the three-dimensional cross-linking polymer matrix without necessitating the application of heat history to the radical polymerizable compound and to the photo-radical polymerization initiator.

Even when the hydrocarbon substituted silanol is replaced by the phenolic compound represented by the aforementioned general formula (3), almost the same effects as described above can be obtained.

Moreover, the catalytic components such as the hydrocarbon substituted silanol represented by the aforementioned general formula (2), the phenolic compound represented by the aforementioned general formula (3), and the metal complex represented by any one of the aforementioned general formulas (4), (5) and (6) are enabled to exist in the polymer matrix without reacting with the three-dimensional cross-linking polymer matrix that has been obtained through the polymerization. Further, the generation of ionic impurities can be prevented.

When light is irradiated to a predetermined region of the recording layer comprising the three-dimensional cross-linking polymer matrix, the radical polymerizable compound and the photo-radical polymerization initiator to perform the exposure of the recording layer, the radical polymerizable compound is caused to move to the exposed region. The space created by this moving of the radical polymerizable compound is then occupied by the catalytic components existing in the polymer matrix. As a result, the change in refractive index becomes more prominent.

Even if a reaction between the catalytic components happens to generate, there would not be raised any problem. In view of the easiness to control the shrinkage and strain of the recording medium, it is more preferable to employ the phenolic compound represented by the general formula (3) rather than the hydrocarbon substituted silanol represented by the general formula (2), since it is possible, by the employment of the phenolic compound, to prevent violent reaction and hence to retard the reaction rate.

Further, these catalytic components would not give rise to the generation of decomposition products such as alcohol or impurities. Water is not required to be existed in the recording medium on the occasion of effecting the catalytic action and therefore it is possible to employ a stable dried recording medium.

The catalytic components such as the metal complex and hydrocarbon substituted silanol described above act to strengthen the adhesion between the substrate sustaining the recording medium and the recording layer. When a molecule which is highly polarized therein such as the metal complex co-exist with the hydroxyl group of silanol in the recording layer, the adhesion of the recording layer to various substrates such as those made of glass, polycarbonate, acrylic resin, polyethylene terephthalate (PET), etc., can be enhanced.

When the adhesion of the recording layer to the substrate is enhanced, it is possible to prevent the peel-off of the recording layer even if the shrinkage or expansion of volume generate at a minute exposed region or unexposed region at the moment of writing information by interference light wave.. Since the information thus recorded can be maintained without generating any distortion, it is possible to further enhance the recording performance. Further, the metal complex and hydrocarbon substituted silanol exist in the polymer matrix without being deactivated.

For this reason, the information thus written can be fixed through the post-baking of the recording medium, thus making it possible to prevent the changes with time of the information. When the recording medium is subjected to exposure by interference light wave, the radical polymerizable compound is enabled to polymerize to increase the density of the exposed region, thus increasing the refractive index. On the other hand, at the unexposed region, the density thereof is reduced due to the moving of the radical polymerizable compound therefrom, thus decreasing the refractive index. The moving of the radical polymerizable compound in this case can be increasingly facilitated as the polymer

matrix of the recording medium is lower in density. Namely, as the density of cross-linking of the three-dimensional cross-linking polymer matrix becomes lower, the moving of the radical polymerizable compound can be increasingly facilitated, thus giving a recording medium which is higher in sensitivity.

However, in the case of the three-dimensional cross-linking polymer matrix which is low in the density of cross-linking, the radical polymerizable compound or the polymer thereof is liable to move into an unexposed region which is spatially low in density. Therefore, the density of cross-linking of the polymer matrix should preferably be decreased so as to enable the radical polymerizable compound to more easily move on the occasion of recording information through the exposure of recording layer to an interference light wave. After the information has been written in the recording layer however, when the information is desired to be fixed, it will be effective to enhance the density of cross-linking of the polymer matrix by post-baking. Since the recording medium according to one embodiment is enabled to increase the density of cross-linking of the polymer matrix by post-baking, the recording performance of the recording medium can be improved.

The post-baking should preferably be performed at a temperature ranging from 40 to 100°C. If the temperature of post-baking is lower than 40°C, it may become difficult to enhance the density of cross-linking of the polymer matrix. On the other hand, if the temperature of post-baking exceeds 100°C, the molecular motion of the polymer matrix would be activated, thereby possibly making it impossible to read out the recorded information as the information recorded therein change.

As described above, on the occasion of recording the information by interference light wave, the density of the recording layer increases at the exposed region, while the density of unexposed region is lowered. Due to a difference in density of the recording layer, the catalytic components such as the metal complex and hydrocarbon substituted silanol move from the exposed region to the unexposed region. This movement of these catalytic components promotes the moving of the radical polymerizable compound to the exposed region. Further, the catalytic components that have been moved to the unexposed region of the recording layer act to degrade the refractive index of the unexposed region thereof.

The three-dimensional cross-linking polymer matrix (the cured product of epoxy resin) that has been polymerized using the metal complex and hydrocarbon substituted silanol as catalysts is transparent to the light ranging from visible light to ultraviolet ray and has an optimal hardness. Namely, since the polymer matrix is transparent to the exposure wavelength, the absorption of light by the photo-radical polymerization initiator cannot be obstructed, thereby making it possible to obtain a three-dimensional cross-linking polymer matrix having a suitable degree of hardness for enabling the radical polymerizable compound to appropriately diffuse therein. As a result, it is now possible to manufacture a holographic recording medium which is excellent in sensitivity and diffraction efficiency. Furthermore, since the three-dimensional cross-linking polymer matrix has a suitable degree of hardness, it is possible to inhibit the recording layer from being shrunk at the region where the polymerization of the radical polymerizable compound has taken place.

The employment of the aforementioned epoxy monomer in the formation of the three-dimensional cross-linking polymer matrix is advantageous in the following respects. Namely, when the aforementioned epoxy monomer is employed, it is possible to obviate any possibility of obstructing the moving of the radical polymerizable compound to be generated on the occasion of exposure. The reasons for this can be explained as follows. First of all, it is possible to secure a sufficient space for enabling the radical polymerizable compound to move for forming the three-dimensional cross-linking polymer matrix. Further, there is little possibility of locally enhancing the density of cross-linking. Furthermore, since the polarity of the polymer matrix is low, the moving of the radical polymerizable compound cannot be obstructed. Therefore, it is now.possible to excellently perform the writing of hologram.

The state of the polymer matrix which makes it realize excellent moving of the radical polymerizable compound can be assessed by durometer hardness. This durometer hardness is employed in the method of measuring the hardness of rubber and can be measured in accordance with JIS K 6253. This durometer hardness agrees with the international standard ISO 7619. The durometer hardness of the polymer matrix at room temperature should preferably be confined within the range of A45 to A85. As long as the durometer hardness of the polymer matrix is confined within this range, the polymer matrix is assumed as being in a state where the moving of the radical polymerizable compound would not be obstructed. More preferably, the value of durometer hardness should be confined within the range of A55 to A75.

In order to increase the diffraction efficiency of the recording medium, the compound represented by the following general formula (7) may be incorporated into the recording layer.

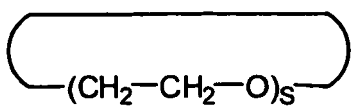

(7)

In the general formulas (7), s is an integer of 3 to 30. When the moving velocity of this compound in the polymer matrix is taken into consideration, s should preferably be confined to not more than 6. The general formulas (7) is formed

of an ethylene oxide skeleton and is excellent in affinity with the polymer matrix comprising an alkyl chain and an ethylene oxide skeleton. Because of this, it is possible to create a homogeneous medium without generating phase separation. Further, since this compound represented by the general formula (7) is formed of a cyclic structure, it has no terminal polar group and maintains a constant cyclic structure, thereby enabling it to diffuse very uniformly and swiftly.

As described above, the three-dimensional cross-linking polymer matrix represented by the aforementioned general formula (1) can be created through the radical polymerization of the epoxy monomer represented by the aforementioned general formula (9). On the occasion of the radical polymerization, a polymer component represented by the following general formula (8) may be occasionally generated.

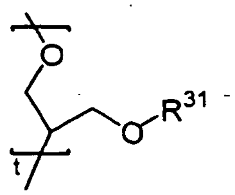

(8)

(in the general formulas (8), $R^{31}$ is unsubstituted alkyl group having 1 to 12 carbon atoms, methoxyethyl group or methoxyethoxyethyl group)

When this skeleton is existed in the three-dimensional cross-linking polymer matrix, the flexibility of the three-dimensional cross-linking polymer matrix can be further enhanced. Since the skeleton represented by the general formula (8) is also excellent in affinity with the materials of the three-dimensional cross-linking polymer matrix, it is possible to maintain a uniform recording medium.

On the occasion of manufacturing the recording layer of the holographic recording medium according to one embodiment, the radical polymerizable compound and the photo-radical polymerization initiator are mixed with each other together with the aforementioned epoxy monomer and the catalytic components, thereby preparing a raw material solution for the recording layer.

As the radical polymerizable compound, it is possible to employ compounds having an ethylenic unsaturated double bond. For example, unsaturated carboxylic acid, unsaturated carboxylate, unsaturated carboxylic acid amide and vinyl compounds can be employed as the radical polymerizable compound. Examples of the radical polymerizable compound include acrylic acid, methyl acrylate, ethyl acrylate, propyl acrylate, butyl acrylate, isobutyl acrylate, 2-ethylhexyl acrylate, octyl acrylate, lauryl acrylate, stearyl acrylate, cyclohexyl acrylate, bicyclopentyl acrylate, phenyl acrylate, isobonyl acrylate, adamantyl acrylate, methacrylic acid, methyl methacrylate, propyl methacrylate, butyl methacrylate, phenyl methacrylate, phenoxyethyl acrylate, chlorophenyl acrylate, adamantyl methacrylate, isobonyl methacrylate, N-methyl acrylic amide, N,N-dimethyl acrylic amide, N,N-methylene bisacrylic amide, acryloyl morpholine, vinyl pyridine, styrene, bromostyrene, chlorostyrene, tribromophenyl acrylate, trichlorophenyl acrylate, tribromophenyl methacrylate, trichlorophenyl methacrylate, vinyl benzoate, 3,5-dichlorovinyl benzoate, vinyl naphthalene, vinyl naphthoate, naphthyl methacrylate, naphthyl acrylate, N-phenyl methacryl amide, N-phenyl acryl amide, N-vinyl pyrrolidinone, N-vinyl carbazole, 1-vinyl imidazole, bicyclopentenyl acrylate, 1,6-hexanediol diacrylate, pentaerythritol triacrylate, pentaerythritol tetraacrylate, dipentaerythritol hexaacrylate, diethylene glycol diacrylate, polyethylene glycol diacrylate, polyethylene glycol dimethacrylate, tripropylene glycol diacrylate, propylene glycol trimethacrylate, diallyl phthalate, triallyl trimellitate, etc.

These radical polymerizable compounds should preferably be incorporated in the recording layer at a content ranging from 1 to 50% by weight based on a total weight of the recording layer. If the content of these radical polymerizable compounds is less than 1% by weight, it is impossible to sufficiently enhance the refractive index of the recorded region. On the other hand, if the content of these radical polymerizable compounds exceeds 50% by weight, the volume shrinkage of the recording layer would become too large, thus possibly deteriorating the resolution. More preferably, the content of the radical polymerizable compound should be confined to 3 to 30% by weight based on a total weight of the recording layer.

As the photo-radical polymerization initiator, it is possible to employ, for example, imidazole derivatives, organic azide compounds, titanocene, organic peroxides, and thioxanthone derivatives.

Examples of the photo-radical polymerization initiator include benzyl, benzoin, benzoin ethyl ether, benzoin isopropyl ether, benzoin butyl ether, benzoin isobutyl ether, 1-hydroxycyclohexyl phenyl ketone, benzyl methyl ketal, benzyl ethyl ketal, benzyl methoxyethyl ether, 2,2'-diethylacetophenone, 2,2'-dipropylacetophenone, 2-hydroxy-2-methylpropiophenone, p-tert-butyltrichloroacetophenone, thioxanthone, 2-chlorothioxanthone, 3,3',4,4'-tetra(t-butyl peroxycarbonyl)benzophenone, 2,4,6-tris(trichloromethyl)1,3,5-triazine, 2-(p-methoxyphenyl)-4,6-bis(trichloromethyl)1,3,5-triazine, 2-[(p-methoxyphenyl)ethylene]-4,6-bis(trichloromethyl)1,3,5-triazine, Irgacure 149, 184, 369, 651, 7'84, 819, 907, 1700, 1800, 1850 (Chiba Speciality Chemicals Co., Ltd.), di-t-butyl peroxide, dicumyl peroxide, t-butylcumyl peroxide,

t-butyl peroxyacetate, t-butyl peroxyphthalate, t-butyl peroxybenzoate, acetyl peroxide, isobutyryl peroxide, decanoyl peroxide, lauroyl peroxide, benzoyl peroxide, t-butyl hydroperoxide, cumene hydroperoxide, methylethyl ketone peroxide, cyclohexanone peroxide, etc.

These photo-radical polymerization initiators should preferably be incorporated in the raw material solution at a content ranging from 0.1 to 10% by weight based on the radical polymerizable compound. If the content of these photo-radical polymerization initiators is less than 0.1% by weight, it may become impossible to obtain a sufficient change in refractive index. On the other hand, if the content of these photo-radical polymerization initiators exceeds 10% by weight, the light absorption by the recording layer would become too large, thus possibly deteriorating the resolution. More preferably, the content of the photo-radical polymerization initiator should be confined to 0.5 to 6% by weight based on the radical polymerizable compound.

If necessary, a sensitizing dye such as cyanine, merocyanine, xanthene, coumalin, eosin, etc., a silane coupling agent and a plasticizer may be incorporated in the raw material solution for the recording layer.

Predetermined components described above are mixed together to prepare the raw material solution for the recording layer. Using the raw material solution for the recording layer thus prepared, a resin layer is deposited on a predetermined substrate and then the three-dimensional cross-linking polymer matrix is created, thus forming the recording layer.

For example, the raw material solution for the recording layer is coated on a light-transmitting substrate to form a resin layer. As the light-transmitting substrate, it is possible, for example, a glass substrate or a plastic substrate. The coating of the raw material solution can be performed by casting or spin-coating method. Alternatively, the raw material solution for the recording layer may be poured into a space formed between a pair of glass substrates which are superimposed via a resin spacer, thus forming a resin layer.

The resin layer thus formed is then heated using an oven, a hot plate, etc., to proceed the radical polymerization of epoxy monomer, thus forming the three-dimensional cross-linking polymer matrix. The temperature in this heating step should be 10°C or more and lower than 80°C. If this heating temperature is lower than 10°C, it may become difficult to create the three-dimensional cross-linking. On the other hand, if this heating temperature exceeds 80°C, the polymerization reaction may become vigorous, thereby narrowing the voids of the three-dimensional cross-linking polymer matrix. As a result, the moving velocity of the monomer in the polymer matrix may be degraded. Further, if this heating temperature exceeds 80°C, the reaction of monomer may take place. Since this reaction takes place sufficiently even at room temperature, it is preferable to employ a method to cure the resin layer at room temperature. The temperature for heating the resin layer should preferably be 10°C or more and lower than 60°C.

The thickness of the recording layer is preferably be confined within the range of 0.1 to 5 mm. If the film thickness of the recording layer is less than 0.1 mm, the angular resolution may deteriorate, thereby making it difficult to perform multiple recording. On the other hand, if the film thickness of the recording layer exceeds 5 mm, the transmissivity of the recording layer may be lowered, thus deteriorating the performance of the recording layer. More preferably, the thickness of the recording layer should be confined within the range of 0.2 to 2 mm.

On the occasion of performing the recording in the holographic recording medium according to one embodiment, information beam as well as reference beam is irradiated into the recording medium. By enabling these two beams to interfere in the interior of the recording layer, the recording or the regeneration of the hologram is performed. As for the type of hologram (holography) to be recorded, it may be either a transmission type hologram (transmission type holography) or a reflection type hologram (reflection type holography). As for the method of generating the interference between the information beam and the reference beam, it may be a two-beam interference method or a coaxial interference method.

FIG. 1 shows a diagram schematically illustrating the holographic recording medium to be employed in the transmission type holographic recording medium and also illustrating the information beam and the reference beam to be irradiated in the vicinity of the holographic recording medium. As shown in FIG. 1, the holographic recording medium 12 is composed of a pair of transparent substrates 17, between which a spacer 18 and a recording layer 19 are sandwiched. The transparent substrates 17 are respectively made of glass or plastics such as polycarbonate. The recording layer 19 comprises a specific kind of three-dimensional cross-linking polymer matrix as described above, a radical polymerizable compound, and a photo-radical polymerization initiator.

As an information beam 10 and a reference beam 11 are irradiated into the holographic recording medium 12, these beams are intersected in the recording layer 19. As a result, an interference generate between these beams, thereby creating a transmission type hologram in the modulated region 20.

FIG. 2 is a diagram schematically illustrating one example of the holographic information recording/regenerating apparatus. The holographic information recording/regenerating apparatus shown in FIG. 2 is a hologram type photo-information recording/regenerating apparatus where a transmission type two-beam interference method is utilized.

The beam irradiated from a light source device 1 is introduced, via a beam expander 2 and an optical element 3 for optical rotation, into a polarized beam splitter 4. As for the light source device 1, it is possible to employ a light source which irradiates any kind of light which can be interfered in the recording layer 19 of the holographic recording medium 12. However, in view of coherence, it is preferable to employ a linearly polarized laser. As for the laser, it is

possible to employ a semiconductor laser, an He-Ne laser, an argon laser and a YAG laser.

The beam expander 2 acts to expand the beam irradiated from the light source device 1 to such an extent that the expanded beam is suited for the hologram recording. The optical element 3 for optical rotation acts to bring about the optical rotation of the beam that has been expanded by the beam expander 2, thereby generating a beam comprising an S-polarized beam component and a P-polarized beam component. As for the optical element 3 for optical rotation, it is possible to employ, for example, a half- or quarter-wavelength plate.

Among these beams that have passed through the optical element 3, the S-polarized beam component is reflected by the polarized beam splitter 4 to create an information beam 10, and the P-polarized beam.component pass through the polarized beam splitter 4 to create a reference beam 11. Incidentally, in order to make the strength of information beam 10 identical with that of the reference beam 11 at the position of the recording layer 19 of the holographic recording medium 12, the direction of optical rotation of beam entering into the polarized beam splitter 4 is adjusted by the optical element 3.

The information beam 10 that has been reflected by the polarized beam splitter 4 is again reflected by a mirror 6 and then permitted to pass through an electromagnetic shutter 8 and to irradiate the recording layer 19 of the holographic recording medium 12 which is sustained on a rotary stage 13.

On the other hand, the reference beam 11 that has passed through the polarized beam splitter 4 rotates by 90° in the direction of polarization at an optical element 5 for optical rotation, thereby creating an S-polarized beam. This S-polarized beam is then reflected by a mirror 7 and permitted to pass through an electromagnetic shutter 9. Thereafter, the S-polarized beam is irradiated so as to intersect with the information beam 10 at a location inside the recording layer 19 of the holographic recording medium 12 which is sustained on a rotary stage 13, thereby creating a transmission type hologram formed as a refractive index-modulating region 20.

On the occasion of regenerating the information thus recorded, the electromagnetic shutter 8 is closed to shut off the information beam 10, while enabling only the reference beam 11 to irradiate the transmission type hologram (the refractive index-modulating region 20) which has been created in the recording layer 19 of the holographic recording medium 12. Part of the reference beam 11 is diffracted by the transmission type hologram as it passes through the holographic recording medium 12. The resultant diffracted beam is then detected by a beam detector 15. A reference numeral 14 denotes a beam detector for monitoring the beam passed through the recording medium.

In order to stabilize the hologram that has been recorded through the polymerization of unreacted radical polymerizable compound, an ultraviolet source device 16 and an ultraviolet ray irradiating optical system may be installed as shown in FIG. 2. As this ultraviolet source device 16, it is possible to employ any kind of light source which is capable of irradiating the light that is effective in polymerizing the unreacted radical polymerizable compound. Because of excellence in ultraviolet ray-emitting efficiency, it is preferable to employ, for example, a xenon lamp, a mercury lamp, a high-pressure mercury lamp, a mercury xenon lamp, a gallium nitride-based emission diode, a gallium nitride-based semiconductor laser, an excimer laser, a tertiary harmonics of Nd:YAG laser, and a quaternary harmonics of Nd:YAG laser.

The recording medium according to one embodiment can be employed also as a reflection type hologram recording medium. In this case, the recording of information can be performed as shown in FIG. 3 for example. FIG. 3 is a cross-sectional view schematically illustrating the reflection type holographic recording medium as well as the information beam and the reference beam to be irradiated in the vicinity of the holographic recording medium. As shown in FIG. 3, the holographic recording medium 21 is constituted by a pair of transparent substrates 23 and 25 each made of glass or plastics such as polycarbonate, by a spacer 24 and a recording layer 26 which are sandwiched between these transparent substrates 23 and 25, and by a reflection layer 22 fixed to the substrate 23. The recording layer 26 comprises a specific kind of three-dimensional cross-linking polymer matrix described above, a radical polymerizable compound, and a photo-radical polymerization initiator.

As in the case of the transmission type hologram, even in the case of this reflection type hologram recording medium 21, an information beam and a reference beam 40 are irradiated into the holographic recording medium 12 so as to be intersected in the recording layer 26, thereby generating an interference between these beams and creating a reflection type hologram in the modulated region (not shown).

Next, the method of recording information to the reflection type holographic recording medium 21 will be explained with reference to FIG. 4.

As in the case of the transmission type holographic recording/regenerating apparatus, the light source device 27 of the holographic recording/regenerating apparatus shown in FIG. 4 may be formed of a laser which is capable of emitting a linearly polarized coherent beam. As examples of such a laser, it is possible to employ a semiconductor laser, an He-Ne laser, an argon laser and a YAG laser.

The beam emitted from the light source device 27 is expanded in beam diameter by the beam expander 30 and then transmitted as a parallel beam to the optical element 28 for optical rotation.

The optical element 28 for optical rotation is constructed such that it is enabled to emit, through the rotation of the plane of polarization of the previous beam of light, a beam comprising a polarized beam component where the plane

of polarization is parallel with the plane of drawing (hereinafter referred to as a P-polarized beam component) and a polarized beam component where the plane of polarization is perpendicular to the plane of drawing (hereinafter referred to as a S-polarized beam component). Alternatively, it is possible to enable the optical element 28 to emit, by making the previous beam of light into a circular polarization or an elliptic polarization, a beam comprising a polarized beam component where the plane of polarization is parallel with the plane of drawing and a polarized beam component where the plane of polarization is perpendicular to the plane of drawing. As the optical element 28 for optical rotation, it is possible to employ, for example, a half- or quarter-wavelength plate.

Among these beams that have been emitted from the optical element 28, the S-polarized beam component is reflected by the polarized beam splitter 29 and hence transmitted to a transmission type special beam modulator 31. Meanwhile, the P-polarized beam component o passes through the polarized beam splitter 29. This P-polarized beam component is utilized as a reference beam.

The transmission type special beam modulator 31 is provided with a large number of pixels which are arrayed matrix-like as in the case of a transmission type liquid crystal display device, so that the beam emitted from this special beam modulator 31 can be switched from the P-polarized beam component to the S-polarized beam component and vice versa for each pixel. In this manner, the transmission type special beam modulator 31 emits the information beam provided with a two-dimensional distribution regarding the plane of polarization in conformity with the information to be recorded.

The information beam emitted from this special beam modulator 31 is then permitted to enter into another polarized beam splitter 32. This polarized beam splitter 32 acts to reflect only the S-polarized beam component out of the previous information beam while permitting the P-polarized beam component to pass therethrough.

The S-polarized beam component that has been reflected by the polarized beam splitter 32 passes, as an information beam provided with a two-dimensional intensity distribution, through the electromagnetic shutter 33 and to enter into another polarized beam splitter 37. This information beam is then reflected by the polarized beam splitter 37 and permitted to enter into a halving optical element 38 for optical rotation.

This halving optical element 38 for optical rotation is constructed such that it is partitioned into a right side portion and a left side portion, which differ in optical properties from each other. Specifically, among the information beams, for example, the beam component entering into the right side portion of this halving optical element 38 is emitted therefrom after the plane of polarization thereof has been rotated by an angle of +45° while the beam component entering into the left side portion of this halving optical element 38 is emitted therefrom after the plane of polarization thereof has been rotated by an angle of -45°. The beam component to be derived from the S-polarized beam component whose polarization plane has been rotated by an angle of +45° (or the beam component to be derived from the P-polarized beam component whose polarization plane has been rotated by an angle of -45°) will be hereinafter referred to as an A-polarized beam component, the beam component to be derived from the S-polarized beam component whose polarization plane has been rotated by an angle of -45° (or the beam component to be derived from the P-polarized beam component whose polarization plane has been rotated by an angle of +45°) will be hereinafter referred to as a B-polarized beam component. Incidentally, each of the right and left portions of the halving optical element 38 may be constructed by a half-wavelength plate.

The A-polarized beam component and the B-polarized beam component that have been emitted from the halving optical element 38 are converged on the reflection layer 22 of holographic recording medium 21 by an objective lens 34. Incidentally, the holographic recording medium 21 is arranged such that the transparent substrate 25 faces the objective lens 34.

On the other hand, part of the P-polarized beam component (reference beam) that has passed through the polarized beam splitter 29 is reflected by the beam splitter 39 and then permitted to pass through the polarized beam splitter 37. This reference beam that has passed through the polarized beam splitter 37 is then transmitted into the halving optical element 38. The beam component entering into the right side portion of this halving optical element 38 is emitted therefrom as a B-polarized beam component after the plane of polarization thereof has been rotated by an angle of +45° while the beam component entering into the left side portion of this halving optical element 38 is emitted therefrom as an A-polarized beam component after the plane of polarization thereof has been rotated by an angle of -45°. Subsequently, these A-polarized beam component and B-polarized beam component are converged on the reflection layer 22 of holographic recording medium 21 by an objective lens 34.

As described above, the information beam constituted by the A-polarized beam component and the reference beam constituted by the B-polarized beam component are emitted from the right side portion of the halving optical element 38. On the other hand, the information beam constituted by the B-polarized beam component and the reference beam constituted by the A-polarized beam component are emitted from the left side portion of the halving optical element 38. Furthermore, these information beam and reference beam are enabled to converge on the reflection layer 22 of holographic recording medium 21.

Because of this, the interference between the information beam and the reference beam take place only between the information beam formed of the direct beam that has been directly transmitted into the recording layer 26 through

the transparent substrate 25 and the reference beam formed of the reflection beam that has been reflected by the reflection layer 22, and between the reference beam formed of a direct beam and the information beam formed of a reflection beam. Furthermore, neither the interference between the information beam formed from a direct beam and the information beam formed from a reflection beam, nor the interference between the reference beam formed from a direct beam and the reference beam formed from a reflection beam can be prevented from generating. Therefore, according to the recording/regenerating apparatus shown in FIG. 4, it is possible to generate a distribution of optical properties in the recording layer 26 in conformity with the information beam.

Even in the case of the reflection type holographic recording/regenerating apparatus shown in FIG. 4, it is possible to install the ultraviolet source device and the ultraviolet irradiating optical system as already explained above in order to enhance the stability of the recorded hologram.

The information recorded according to the aforementioned method can be read out as explained below. Namely, the electromagnetic shutter 33 is closed to enable only the reference beam to emit, thus irradiating the recording layer 26 having information recorded therein in advance. As a result, only the reference beam formed of the P-polarized beam component reaches the halving optical element 38.

Due to the effects of the halving optical element 38, this reference beam is processed such that the beam component entering into the right side portion of this halving optical element 38 is emitted therefrom as a B-polarized beam component after the plane of polarization thereof has been rotated by an angle of +45° while the beam component entering into the left side portion of this halving optical element 38 is emitted therefrom as an A-polarized beam component after the plane of polarization thereof has been rotated by an angle of -45°. Subsequently, these A-polarized beam component and B-polarized beam component are converged on the reflection layer 22 of holographic recording medium 21 by the objective lens 34.

In the recording layer 26 of the holographic recording medium 21, there is formed, according to the aforementioned method, a distribution of optical properties created in conformity with the information to be recorded. Accordingly, part of these A-polarized beam component and B-polarized beam component that have been emitted to the holographic recording medium 21 is diffracted by the distribution of optical properties created in the recording layer 26 and is then emitted as a regenerating beam from the holographic recording medium 21.

In the regenerating beam emitted from the holographic recording medium 21, the information beam is reproduced therein, so that the regenerating beam is formed into a parallel beam by the objective lens 34 and then permitted to reach the halving optical element 38. The B-polarized beam component transmitted into the right side portion of the halving optical element 38 is emitted therefrom as the P-polarized beam component. Further, the A-polarized beam component transmitted into the left side portion of the halving optical element 38 is emitted therefrom also as the P-polarized beam component. In this manner, it is possible to obtain a regenerating beam as the P-polarized beam component.

Thereafter, the regenerated beam passes through the polarized beam splitter 37. Part of the regenerating beam that has passed through the polarized beam splitter 37 is then permitted to pass through the beam splitter 39 and transmitted through an image-forming lens 35 to the two-dimensional beam detector 36, thereby reproducing an image of the transmission type special beam modulator 31 on the two-dimensional beam detector 36. In this manner, it is possible to read out the information recorded in the holographic recording medium 21.

On the other hand, the rests of the A-polarized beam component and of the B-polarized beam component that have transmitted through the halving optical element 38 into the holographic recording medium 21 are reflected by the reflection layer 22 and emitted from the holographic recording medium 21. These A-polarized beam component and of B-polarized beam component that have been reflected as a reflection beam is then turned into a parallel beam by the objective lens 34. Subsequently, the A-polarized beam component of this parallel beam is transmitted into the right side portion of the halving optical element 38 and then emitted therefrom as the S-polarized beam component, while the B-polarized beam component of this parallel beam is transmitted into the left side portion of the halving optical element 38 and then emitted therefrom as the S-polarized beam component. Since the S-polarized beam component thus emitted from the halving optical element 38 is reflected by the polarized beam splitter 37, it is impossible for the S-polarized beam component to reach the two-dimensional beam detector 36. Therefore, according to this recording/regenerating apparatus, it is now possible to realize an excellent regenerating signal-to-noise ratio.

The holographic recording medium according to one embodiment can be suitably employed for the multi-layer optical recording and regeneration of information. This multi-layer optical recording and regeneration of information may be of any type, i.e., either the transmission type or the reflection type.

Next, the present invention will be further explained with reference specific examples as follows.

(Example 1)

5.0 g of 1,6-hexanediol diglycidyl ether (epoxy equivalent:151; Nagase Chemitechs Co., Ltd.) employed as an epoxy monomer, and 0.4 g of aluminum tris(ethylacetyl acetate) employed as a metal complex were mixed with each

other in a dark room to obtain a mixture. This mixture was then allowed to dissolve with stirring at a temperature of 60°C to prepare a solution of the metal complex.

Further, 5.0 g of 1,6-hexanediol diglycidyl ether (epoxy equivalent:151; Nagase Chemitechs Co., Ltd.) employed as an epoxy monomer, and 0.6 g of triphenyl silanol employed as hydrocarbon substituted silanol were mixed with each other to obtain a mixture. This mixture was then allowed to dissolve with stirring at a temperature of 60°C to prepare a silanol solution.

The solution of the metal complex and the silanol solution were mixed with each other with stirring. 5 g of the mixed solution thus stirred was taken up and mixed with 0.25 g of a radical polymerizable compound and with 0.0225 g of a photo-radical polymerization initiator. Vinyl naphthalene was employed as a radical polymerizable compound and Irgacure 784 (Chiba Speciality Chemicals Co., Ltd.) was employed as a photo-radical polymerization initiator. Finally, the resultant mixture was subjected to defoaming to obtain a raw material solution for recording layer.

A pair of glass plates was superimposed with a spacer formed of a Teflon (registered trademark) sheet being interposed therebetween to create a space. Then, the aforementioned raw material solution for recording layer was poured into this space. The resultant structure was heated in an oven of 55°C for 24 hours under a light-shielded condition, thereby manufacturing a test piece of the holographic recording medium bearing a recording layer having a thickness of 200 μm.

It was confirmed through the measurement and analysis of this recording layer by a pyrolyzer GC-MS and FT-IR that the creation of the three-dimensional cross-linking polymer matrix which is represented by the aforementioned general formula (1) wherein m is 6. Further, the value of durometer hardness as measured in accordance with JIS K 6253 was A80.

The test piece thus obtained was mounted on the rotary stage 13 of the hologram recording apparatus 1 shown in FIG. 2 to record hologram. As the hologram recording apparatus 1, a semiconductor laser (405 nm) was employed. The beam spot size on the test piece was 5 mm in diameter in each of the information beam 10 and the reference beam 11 and the intensity of the recording beam was adjusted to such that it became 5 mW/cm$^2$ as a total of the information beam 10 and the reference beam 11.

After finishing the recording of hologram, the information beam 10 was shut off by the electromagnetic shutter 8 and only the reference beam 11 was irradiated onto the test piece, admitting the diffracted beam from the test piece. Based on this fact, the existence of transmission type hologram recorded therein was confirmed. When the irradiation of beam at an intensity of 500 mJ/cm$^2$ was performed, a maximum diffraction efficiency of 90% was indicated.

The recording performance of hologram was assessed by M/# (M number) representing a dynamic range of recording. This M/# can be defined by the following formula using $\eta_i$. This $\eta_i$ represents a diffraction efficiency to be derived from i-th hologram as holograms of n pages are subjected to angular multiple recording/regeneration until the recording at the same region in the recording layer of the holographic recording medium becomes no longer possible. This angular multiple recording/regeneration can be performed by irradiating a predetermined beam to the holographic recording medium 12 while rotating the rotary stage 13.

$$M/\# = \sum_{i=1}^{n} \sqrt{\eta i}$$

Incidentally, the diffraction efficiency η was defined by the light intensity It to be detected at the beam detector 14 and the light intensity $I_d$ to be detected at the beam detector 15 on the occasion when only the reference beam 11 was irradiated to the holographic recording medium 12. Namely, the diffraction efficiency η was defined by an inner diffraction efficiency which can be represented by $\eta = I_d/(I_t + I_d)$.

As the value of M/# of the holographic recording medium becomes larger, the dynamic range of recording is further enlarged, thus enabling to enhance the multiple recording performances.

FIG. 5 shows one example of regenerating signal obtained on the occasion when angular multiple recording/regeneration was performed. Further, on the basis of the quantity of shift of angle representing the peak of diffraction efficiency that can be derived from each of the holograms, the volume change (volumetric shrinkage) of the holographic recording layer 19 before and after the holographic recording can be calculated.

In this example, the quantity of exposure per page of hologram was set to 1 mJ/cm$^2$, and the test piece was rotated once by the rotary stage 13 every time the recording of one page was finished. This recording was repeated to perform the holographic angular multiple recording of 30 pages. Further, in order to wait for the accomplishment of reaction, the recording layer was left to stand for 5 minutes without irradiating the beam. Thereafter, the diffraction efficiency η was measured while sweeping the rotary stage, thereby determining the M/# and the volumetric shrinkage.

As a result, the M/# of the recording medium was 3.2, and the volumetric shrinkage due to the recording was 0.10%.

(Example 2)

A raw material solution for recording layer was prepared in the same manner as described in Example 1 except that the radical polymerizable compound was changed to 0.405 g of dimethoxy styrene and that the photo-radical polymerization initiator was changed to 0.025 g of Irgacure 784 (Chiba Speciality Chemicals Co., Ltd.). Using the raw material solution for recording layer thus obtained, a test piece of the holographic recording medium was manufactured by the same procedures as described above.

It was confirmed through the measurement and analysis of this recording layer by a pyrolyzer GC-MS and FT-IR that the creation of the three-dimensional cross-linking polymer matrix which is represented by the aforementioned general formula (1) wherein m is 6. Further, the value of durometer hardness as measured in accordance with JIS K 6253 was A83.

By repeating the same procedures as described in Example 1, the recording of hologram was performed by a semiconductor laser of 405 nm. As a result, a maximum diffraction efficiency of 84% was indicated as the beam was irradiated at an intensity of 670 $mJ/cm^2$. When the M/# and the volumetric shrinkage were measured by repeating the same procedures as described in Example 1, the M/# of the recording medium was 2.6, and the volumetric shrinkage was 0.10%.

(Example 3)

The raw material solution for the recording layer obtained in Example 1 was poured into a space formed between a pair of glass substrates which were superimposed via a spacer formed of a Teflon (registered trademark) sheet. The resultant structure was heated for 5 hours in an oven heated to 55°C while shielding the light, thus forming a test piece of the holographic recording medium having a recording layer having a thickness of 200 $\mu$m.

It was confirmed through the measurement and analysis of this recording layer by a pyrolyzer GC-MS and FT-IR that the creation of the three-dimensional cross-linking polymer matrix which is represented by the aforementioned general formula (1) wherein m is 6. Further, the value of durometer hardness as measured in accordance with JIS K 6253 was A75.

Thereafter, under the same conditions as described in Example 1, the recording of information was performed. Subsequently, the recording layer was post-baked for 5 hours at a temperature of 70°C, thereby fixing the information through the enhancement of the cross-linking density of the polymer matrix. A maximum diffraction efficiency of 93% was indicated as the beam was irradiated at an intensity of 450 $mJ/cm^2$. As a result, the M/# of the recording medium was 3.5, and the volumetric shrinkage due to the recording was 0.07%.

(Example 4)

A test piece of the holographic recording medium was manufactured in the same manner as described in Example 2 except that the photo-radical polymerization initiator was changed to 2,4,6-tribromophenyl acrylate.

It was confirmed through the measurement and analysis of this recording layer by a pyrolyzer GC-MS and FT-IR that the creation of the three-dimensional cross-linking polymer matrix which is represented by the aforementioned general formula (1) wherein m is 6. Further, the value of durometer hardness as measured in accordance with JIS K 6253 was A84.

Thereafter, the recording of hologram was performed in the same manner as described in Example 1. As a result, a maximum diffraction efficiency of 70% was indicated as the beam was irradiated at an intensity of 500 $mJ/cm^2$. As a result, the M/# of the recording medium was 2.0, and the volumetric shrinkage due to the recording was 0.10%.

(Example 5)

A raw material solution for recording layer was prepared in the same manner as described in Example 1 except that the radical polymerizable compound was changed to 0.88 g of vinyl carbazole. The raw material solution for the recording layer thus obtained was poured into a space formed between a pair of glass substrates which were superimposed via a spacer formed of a Teflon (registered trademark) sheet. The resultant structure was left to stand for 60 hours at room temperature while shielding the light, thus forming a test piece of the holographic recording medium having a recording layer having a thickness of 200 $\mu$m.

It was confirmed through the measurement and analysis of this recording layer by a pyrolyzer GC-MS and FT-IR that the creation of the three-dimensional cross-linking polymer matrix which is represented by the aforementioned general formula (1) wherein m is 6. Further, the value of durometer hardness as measured in accordance with JIS K 6253 was A73.

Thereafter, under the same conditions as described in Example 1, the recording of information was performed.

A maximum diffraction efficiency of 93% was indicated as the beam was irradiated at an intensity of 250 mJ/cm$^2$. As a result, the M/# of the recording medium was 9.1, and the volumetric shrinkage due to the recording was 0.10%.

(Example 6)

5.0 g of 1,8-octanediol diglycidyl ether employed as an epoxy monomer, and 0.4 g of aluminum tris(ethylacetyl acetate) employed as a metal complex were mixed with each other in a dark room to obtain a mixture. This mixture was then allowed to dissolve with stirring at a temperature of 60°C to prepare a solution of the metal complex.

Further, 5.0 g of 1,8-octanediol diglycidyl ether employed as an epoxy monomer, and 0.6 g of triphenyl silanol employed as hydrocarbon substituted silanol were mixed with each other to obtain a mixture. This mixture was then allowed to dissolve with stirring at a temperature of 60°C to prepare a silanol solution.

The solution of the metal complex and the silanol solution were mixed with each other with stirring. 5 g of the mixed solution thus stirred was taken up and mixed with 0.88 g of a radical polymerizable compound and with 0.0225 g of a photo-radical polymerization initiator. Vinyl carbazole was employed as a radical polymerizable compound and Irgacure 784 (Chiba Speciality Chemicals Co., Ltd.) was employed as a photo-radical polymerization initiator. Finally, the resultant mixture was subjected to defoaming to obtain a raw material solution for recording layer.

A pair of glass plates was superimposed with a spacer formed of a Teflon (registered trademark) sheet being interposed therebetween to create a space. Then, the aforementioned raw material solution for recording layer was poured into this space. The resultant structure was left to stand for 60 hours under a light-shielded condition, thereby manufacturing a test piece of the holographic recording medium bearing a recording layer having a thickness of 200 μm.

It was confirmed through the measurement and analysis of this recording layer by a pyrolyzer GC-MS and FT-IR that the creation of the three-dimensional cross-linking polymer matrix which is represented by the aforementioned general formula (1) wherein m is 8. Further, the value of durometer hardness as measured in accordance with JIS K 6253 was A72.

Thereafter, under the same conditions as described in Example 1, the recording of information was performed. A maximum diffraction efficiency of 94% was indicated as the beam was irradiated at an intensity of 320 mJ/cm$^2$. As a result, the M/# of the recording medium was 9.7, and the volumetric shrinkage due to the recording was 0.10%.

(Example 7)

A raw material solution for recording layer was prepared in the same manner as described in Example 6 except that the photo-radical polymerization initiator was changed to 0.03 g of a photo-radical polymerization initiator "TAZ-102" (Midori Kagaku Co., Ltd.) and that 0.015 g of 2-isopropyl thioxanten-9-on was further added thereto. Using the raw material solution for recording layer thus obtained, a test piece of the holographic recording medium was manufactured by the same procedures as described in Example 6.

It was confirmed through the measurement and analysis of this recording layer by a pyrolyzer GC-MS and FT-IR that the creation of the three-dimensional cross-linking polymer matrix which is represented by the aforementioned general formula (1) wherein m is 8. Further, the value of durometer hardness as measured in accordance with JIS K 6253 was A73.

By repeating the same procedures as described in Example 1, the recording of hologram was performed. As a result, a maximum diffraction efficiency of 94% was indicated as the beam was irradiated at an intensity of 350 mJ/cm$^2$. As a result, the M/# of the recording medium was 9.6, and the volumetric shrinkage due to the recording was 0.10%.

(Example 8)

5.0 g of 1,10-decanediol diglycidyl ether employed as an epoxy monomer, and 0.4 g of aluminum tris(ethylacetyl acetate) employed as a metal complex were mixed with each other in a dark room to obtain a mixture. This mixture was then allowed to dissolve with stirring at a temperature of 60°C to prepare a solution of the metal complex.

Further, 5.0 g of 1,10-decanediol diglycidyl ether employed as an epoxy monomer, and 0.6 g of triphenyl silanol employed as hydrocarbon substituted silanol were mixed with each other to obtain a mixture. This mixture was then allowed to dissolve with stirring at a temperature of 60°C to prepare a silanol solution.

The solution of the metal complex and the silanol solution were mixed with each other with stirring. 4.75 g of the mixed solution thus stirred was taken up and mixed with 0.88 g of a radical polymerizable compound and with 0.0225 g of a photo-radical polymerization initiator. Vinyl carbazole was employed as a radical polymerizable compound and Irgacure 784 (Chiba Speciality Chemicals Co., Ltd.) was employed as a photo-radical polymerization initiator. After 0.25 g of 18-Crown-6™ was further incorporated therein, the resultant mixture was subjected to defoaming to obtain a raw material solution for recording layer.

A pair of glass plates was superimposed with a spacer formed of a Teflon (registered trademark) sheet being

interposed therebetween to create a space. Then, the aforementioned raw material solution for recording layer was poured into this space. The resultant structure was left to stand for 60 hours under a light-shielded condition, thereby manufacturing a test piece of the holographic recording medium bearing a recording layer having a thickness of 200 μm.

It was confirmed through the measurement and analysis of this recording layer by a pyrolyzer GC-MS and FT-IR that the creation of the three-dimensional cross-linking polymer matrix which is represented by the aforementioned general formula (1) wherein m is 10. Further, the value of durometer hardness as measured in accordance with JIS K 6253 was A68.

Thereafter, under the same conditions as described in Example 1, the recording of information was performed. A maximum diffraction efficiency of 94% was indicated as the beam was irradiated at an intensity of 180 mJ/cm$^2$. As a result, the M/# of the recording medium was 10.2, and the volumetric shrinkage due to the recording was 0.10%.

(Example 9)

5.0 g of 1,10-decanediol diglycidyl ether employed as an epoxy monomer, and 0.4 g of aluminum tris(ethylacetyl acetate) employed as a metal complex were mixed with each other in a dark room to obtain a mixture. This mixture was then allowed to dissolve with stirring at a temperature of 60°C to prepare a solution of the metal complex.

Further, 4.75 g of 1,10-decanediol diglycidyl ether employed as an epoxy monomer, 0.25 g of hexanol glycidyl ether employed also as an epoxy monomer, and 0.6 g of triphenyl silanol employed as hydrocarbon substituted silanol were mixed with each other to obtain a mixture. This mixture was then allowed to dissolve with stirring at a temperature of 60°C to prepare a silanol solution.

The solution of the metal complex and the silanol solution were mixed with each other with stirring. 5 g of the mixed solution thus stirred was taken up and mixed with 0.88 g of a radical polymeric compound and with 0.0225 g of a photo-radical polymerization initiator. Vinyl carbazole was employed as a radical polymerizable compound and Irgacure 784 (Chiba Speciality Chemicals Co., Ltd.) was employed as a photo-radical polymerization initiator. Finally, the resultant mixture was subjected to defoaming to obtain a raw material solution for recording layer.

A pair of glass plates was superimposed with a spacer formed of a Teflon (registered trademark) sheet being interposed therebetween to create a space. Then, the aforementioned raw material solution for recording layer was poured into this space. The resultant structure was left to stand for 60 hours under a light-shielded condition, thereby manufacturing a test piece of the holographic recording medium bearing a recording layer having a thickness of 200 μm.

It was confirmed through the measurement and analysis of this recording layer by a pyrolyzer GC-MS and FT-IR that the creation of the three-dimensional cross-linking polymer matrix which is represented by the aforementioned general formula (1) wherein m is 10. Further, the value of durometer hardness as measured in accordance with JIS K 6253 was A70.

Thereafter, under the same conditions as described in Example 1, the recording of information was performed. A maximum diffraction efficiency of 94% was indicated as the beam was irradiated at an intensity of 190 mJ/cm$^2$. As a result, the M/# of the recording medium was 10.0, and the volumetric shrinkage due to the recording was 0.10%.

(Example 10)

5.0 g of 1,12-dodecanediol diglycidyl ether employed as an epoxy monomer, and 0.4 g of aluminum tris(ethylacetyl acetate) employed as a metal complex were mixed with each other in a dark room to obtain a mixture. This mixture was then allowed to dissolve with stirring at a temperature of 60°C to prepare a solution of the metal complex.

Further, 5.0 g of 1,12-dodecanediol diglycidyl ether employed as an epoxy monomer, and 0.6 g of triphenyl silanol employed as hydrocarbon substituted silanol were mixed with each other to obtain a mixture. This mixture was then allowed to dissolve with stirring at a temperature of 60°C to prepare a silanol solution.

The solution of the metal complex and the silanol solution were mixed with each other with stirring. 5 g of the mixed solution thus stirred was taken up and mixed with 0.88 g of a radical polymerizable compound and with 0.0225 g of a photo-radical polymerization initiator. Vinyl carbazole was employed as a radical polymerizable compound and Irgacure 784 (Chiba Speciality Chemicals Co., Ltd.) was employed as a photo-radical polymerization initiator. Finally, the resultant mixture was subjected to defoaming to obtain a raw material solution for recording layer.

A pair of glass plates was superimposed with a spacer formed of a Teflon (registered trademark) sheet being interposed therebetween to create a space. Then, the aforementioned raw material solution for recording layer was poured into this space. The resultant structure was left to stand for 60 hours under a light-shielded condition, thereby manufacturing a test piece of the holographic recording medium bearing a recording layer having a thickness of 200 μm.

It was confirmed through the measurement and analysis of this recording layer by a pyrolyzer GC-MS and FT-IR that the creation of the three-dimensional cross-linking polymer matrix which is represented by the aforementioned general formula (1) wherein m is 12. Further, the value of durometer hardness as measured in accordance with JIS K 6253 was A65.

Thereafter, under the same conditions as described in Example 1, the recording of information was performed. A maximum diffraction efficiency of 93% was indicated as the beam was irradiated at an intensity of 170 mJ/cm$^2$. As a result, the M/# of the recording medium was 11.0, and the volumetric shrinkage due to the recording was 0.10%.

(Example 11)

A test piece of the holographic recording medium was manufactured by repeating the same procedures as described in Example 1 except that the heating temperature in the oven was changed to 75°C.

It was confirmed through the measurement and analysis of this recording layer by a pyrolyzer GC-MS and FT-IR that the creation of the three-dimensional cross-linking polymer matrix which is represented by the aforementioned general formula (1) wherein m is 6. Further, the value of durometer hardness as measured in accordance with JIS K 6253 was A83.

By repeating the same procedures as described in Example 1, the recording of hologram was performed by a semiconductor laser of 405 nm. As a result, a maximum diffraction efficiency of 90% was indicated as the beam was irradiated at an intensity of 600 mJ/cm$^2$. When the M/# and the volumetric shrinkage were measured in the same manner as described in Example 1, the M/# of the recording medium was 2.8, and the volumetric shrinkage due to the recording was 0.07%.

It will be recognized from the comparison of these results with the results of Example 1 that it was possible, according to this example, to further minimize the volumetric shrinkage and to increase the hardness of the polymer matrix. It was assumed that, due to the high heating temperature of 75°C, the reaction of epoxy resin was permitted to proceed, thereby creating a region where the monomer was hardly enabled to move in the polymer matrix.

(Comparative Example 1)

8.7 g of ethyleneglycol diglycidyl ether employed as an epoxy monomer, 16.8 g of methylhexahydrophthalate anhydride employed as an acid anhydride, and 0.32 g of DMP-30 (2,4,6-tris(dimethylaminomethyl) phenol) employed as a curing promotor were mixed with each other in a dark room to obtain a mixture.

To this mixture were added 8.10 g of N-vinyl carbazole employed as a radical polymerizable compound and 0.20 g of Irgacure 784 (Chiba Speciality Chemicals Co., Ltd.) employed as a photo-radical polymerization initiator to form a mixture. This mixture was then subjected to de-foaming to obtain a raw material solution for recording layer. Using this raw material and by repeating the same procedure as described in Example 1, a test piece of the holographic recording medium was manufactured.

When the recording layer was measured and analyzed by a pyrolyzer GC-MS and FT-IR, it was impossible to confirm the formation of the three-dimensional cross-linking polymer matrix which is represented by the aforementioned general formula (1). Further, the value of durometer hardness as measured in accordance with JIS K 6253 was A93.

Thereafter, when the recording of hologram was performed by the semiconductor laser of 405 nm under the same conditions as described in Example 1, the diffraction efficiency was gradually increased as the energy of irradiation was further increased. Even if the beam was irradiated at an intensity of 1000 mJ/cm$^2$, the diffraction efficiency was at most 38%. When the M/# and the volumetric shrinkage were measured in the same manner as described in Example 1, the M/# of the recording medium was 0.3, and the volumetric shrinkage due to the recording was 0.10%.

(Comparative Example 2)

17.6 g of polypropyleneglycol diglycidyl ether (epoxy equivalent:176; Nagase Chemitechs Co., Ltd.) employed as an epoxy monomer, 26.6 g of dodecenyl succinate anhydride employed as an acid anhydride, and 0.44 g of DMP-30 (2,4,6-tris(dimethylaminomethyl) phenol) employed as a curing promotor were mixed with each other in a dark room to obtain a mixture.

To this mixture were added 11.05 g of N-vinyl carbazole employed as a radical polymerizable compound and 0.28 g of Irgacure 784 (Chiba Speciality Chemicals Co., Ltd.) employed as a photo-radical polymerization initiator to form a mixture. This mixture was then subjected to de-foaming to obtain a raw material solution for recording layer.

When the recording layer was measured and analyzed by a pyrolyzer GC-MS and FT-IR, it was impossible to confirm the formation of the three-dimensional cross-linking polymer matrix which is represented by the aforementioned general formula (1). Further, the value of durometer hardness as measured in accordance with JIS K 6253 was A32.

By repeating the same procedures as described in Example 1, a test piece of holographic recording medium was prepared. Thereafter, when the recording of hologram was performed by the semiconductor laser of 405 nm in the same manner as described in Example 1, the diffraction efficiency was gradually increased as the energy of irradiation was further increased. Even if the beam was irradiated at an intensity of 1000 mJ/cm$^2$, the diffraction efficiency was at most 32%. When the M/# and the volumetric shrinkage were measured in the same manner as described in Example

1, the M/# of the recording medium was 0.1, and the volumetric shrinkage due to the recording was 4.0%.

According to the embodiment of the present invention, it is possible to provide a holographic recording medium which is high in recording capacity and in refractive index modulation and is minimal in volumetric change that may be caused by the irradiation of beam.

## Claims

1. A holographic recording medium (12) comprising a recording layer (19) containing:

   a three-dimensional cross-linking polymer matrix;
   a radical polymerizable compound; and
   a photo-radical polymerization initiator, **characterized in that** the three-dimensional cross-linking polymer matrix is represented by the following general formula (1):

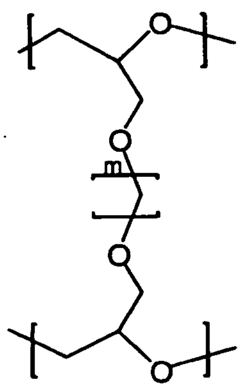

(1)

   wherein m is an integer ranging from 3 to 16.

2. The holographic recording medium according to claim 1, **characterized in that** m in the general formula (1) is an integer of 8 to 12.

3. The holographic recording medium according to claim 1, **characterized in that** the recording layer further comprises at least one compound selected from a hydrocarbon substituted silanol represented by the following general formula (2) and a phenolic compound represented by the following general formula (3):

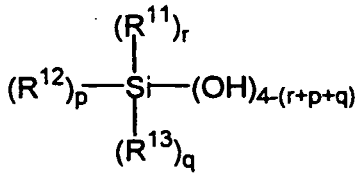

(2)

   wherein $R^{11}$, $R^{12}$ and $R^{13}$ may be the same or different and are individually substituted or unsubstituted alkyl group having 1 to 30 carbon atoms, substituted or unsubstituted aromatic group having 6 to 30 carbon atoms, or substituted or unsubstituted aromatic heterocyclic group having 3 to 30 carbon atoms; and p, q and r are individually an integer of 0 to 3 with a proviso that p+q+r is 3 or less;

   $R^{14}$-Ar-OH (3)

   wherein $R^{14}$ is substituted or unsubstituted alkyl group having 1 to 30 carbon atoms, or substituted aromatic group having 6 to 30 carbon atoms; and Ar is substituted or unsubstituted aromatic group having 3 to 30 carbon atoms.

4. The holographic recording medium according to claim 1, **characterized in that** the recording layer further comprises

at least one kind of compounds represented by the following general formulas (4), (5) and (6):

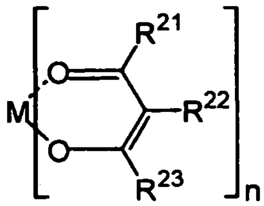

(4)

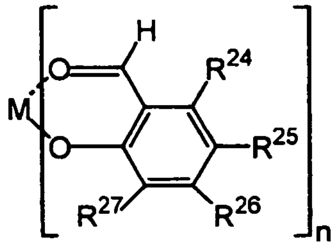

(5)

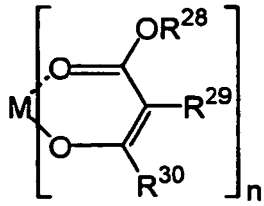

(6)

where M is selected from the group consisting of Al, Ti, Cr, Mn, Fe, Co, Ni, Cu, Zr, Zn, Ba, Ca, Ce, Pb, Mg, Sn and V; $R^{21}$, $R^{22}$ and $R^{23}$ may be the same or different and are individually hydrogen atom, substituted or unsubstituted alkyl group having 1 to 10 carbon atoms; $R^{24}$, $R^{25}$, $R^{26}$ and $R^{27}$ may be the same or different and are individually hydrogen atom, substituted or unsubstituted alkyl group having 1 to 10 carbon atoms; $R^{28}$, $R^{29}$ and $R^{30}$ may be the same or different and are individually hydrogen atom, substituted or unsubstituted alkyl group having 1 to 10 carbon atoms; and n is an integer of 2 to 4.

5. The holographic recording medium according to claim 3, **characterized in that** the compound represented by the general formula (2) is diphenyl disilanol or triphenyl silanol.

6. The holographic recording medium according to claim 4, **characterized in that** the M in the general formulas (4), (5) and (6) is Al.

7. The holographic recording medium according to claim 4, **characterized in that** the compound represented by the general formula (4) is acetyl acetone complex.

8. The holographic recording medium according to claim 4, **characterized in that** the compound represented by the general formula (6) is ethyl acetate complex.

9. The holographic recording medium according to claim 1, **characterized in that** the radical polymerizable compound is vinylcarbazole or vinylnaphthalene.

10. The holographic recording medium according to claim 4, **characterized in that** the compound represented by the general formula (2) is triphenyl silanol, the compound represented by the general formula (6) is aluminium ethylacetate complex, and the radical polymerizable compound is vinylcarbazole or vinylnaphthalene.

11. The holographic recording medium according to claim 1, **characterized in that** the recording layer further comprises a compound represented by the following general formula (7):

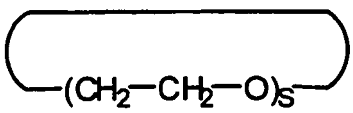

(7)

where s is an integer of 3 to 30.

12. The holographic recording medium according to claim 11, **characterized in that** s in the general formula (7) is an integer of 3 to 6.

13. The holographic recording medium according to claim 1, **characterized in that** the recording layer further comprises a compound represented by the following general formula (8):

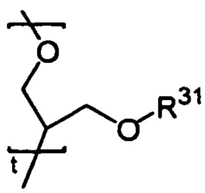

(8)

where $R^{31}$ is unsubstituted alkyl group having 1 to 12 carbon atoms, methoxyethyl group or methoxyethoxyethyl group.

**14.** A method of manufacturing a holographic recording medium **characterized by** comprising:

mixing an epoxy monomer, a hydrocarbon substituted silanol, a metal complex, a photo-radical polymerization initiator, and a radical polymerizable compound to obtain a raw material solution for a recording layer;
coating the raw material solution on a light-transmitting substrate or interposing the raw material solution between a pair of facing light-transmitting substrates to form a resin layer; and
heating the resin layer at a temperature within a range of 10°C to less than 80°C to polymerize the epoxy monomer, thereby forming a recording layer comprising a three-dimensional cross-linking polymer matrix represented by the following general formula (1):

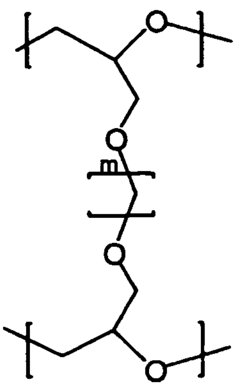

(1)

wherein m is an integer ranging from 3 to 16.

**15.** The method according to claim 14, **characterized in that** the epoxy monomer is a compound represented by the following general formula (9):

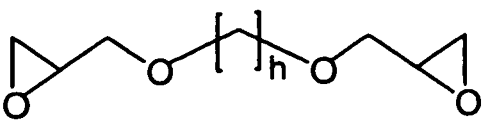

(9)

where h is an integer ranging from 8 to 12.

**16.** The method according to claim 14, **characterized in that** the hydrocarbon substituted silanol is a compound represented by the following general formula (2):

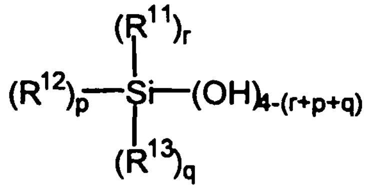

(2)

where $R^{11}$, $R^{12}$ and $R^{13}$ may be the same or different and are individually substituted or unsubstituted alkyl group having 1 to 30 carbon atoms, substituted or unsubstituted aromatic group having 6 to 30 carbon atoms, or substituted or unsubstituted aromatic heterocyclic group having 3 to 30 carbon atoms; and p, q and r are individually an integer of 0 to 3 with a proviso that p+q+r is 3 or less.

**17.** The method according to claim 14, **characterized in that** the metal complex is a compound represented by the following general formulas (4), (5) or (6):

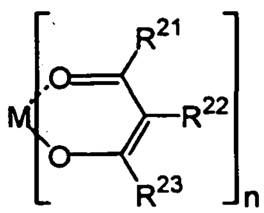

(4)

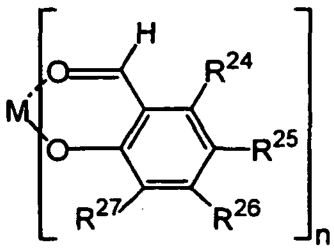

(5)

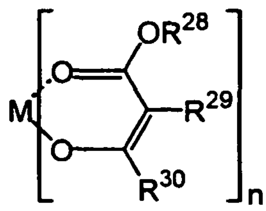

(6)

where M is selected from the group consisting of Al, Ti, Cr, Mn, Fe, Co, Ni, Cu, Zr, Zn, Ba, Ca, Ce, Pb, Mg, Sn and V; $R^{21}$, $R^{22}$ and $R^{23}$ may be the same or different and are individually hydrogen atom, substituted or unsubstituted alkyl group having 1 to 10 carbon atoms; $R^{24}$, $R^{25}$, $R^{26}$ and $R^{27}$ may be the same or different and are individually hydrogen atom, substituted or unsubstituted alkyl group having 1 to 10 carbon atoms; $R^{28}$, $R^{29}$ and $R^{30}$ may be the same or different and are individually hydrogen atom, substituted or unsubstituted alkyl group having 1 to 10 carbon atoms; and n is an integer of 2 to 4.

**18.** The method according to claim 14, **characterized in that** the photo-radical polymerization initiator is selected from the group consisting of imidazole derivatives, organic azide compounds, titanocenes, organic peroxides, thioxanthone derivatives and onium salts.

**19.** The method according to claim 14, **characterized in that** the radical polymerizable compound is selected from the group consisting of vinyl compounds, acrylic compounds and methacrylic compounds.

**20.** The method according to claim 14, **characterized in that** the resin layer is formed to have a thickness ranging from 0.1 to 1.5 mm.

## Patentansprüche

**1.** Holografisches Aufzeichnungsmedium (12), umfassend eine Aufzeichnungsschicht (19), enthaltend:

eine dreidimensional vernetzte Polymermatrix;
eine radikalpolymerisierbare Verbindung; und
einen Fotoradikal-Polymerisationsinitiator;
**dadurch gekennzeichnet; dass** die dreidimensional vernetzte Polymermatrix durch die folgende allgemeine Formel (1) dargestellt ist:

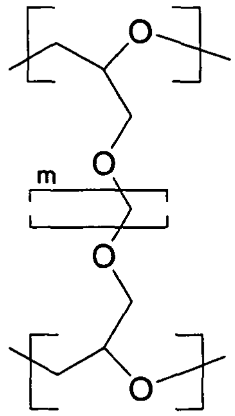

(1)

worin m eine ganze Zahl im Bereich von 3 bis 16 ist.

**2.** Holografisches Aufzeichnungsmedium gemäss Anspruch 1, **dadurch gekennzeichnet, dass** m in der allgemeinen Formel (1) eine ganze Zahl von 8 bis 12 ist.

**3.** Holografisches Aufzeichnungsmedium gemäss Anspruch 1, **dadurch gekennzeichnet, dass** die Aufzeichnungsschicht ferner mindestens eine Verbindung, ausgewählt aus Kohlenstoff-substituiertem Silanol der folgenden allgemeinen Formel (2) und einer phenolischen Verbindung der folgenden allgemeinen Formel (3), umfasst:

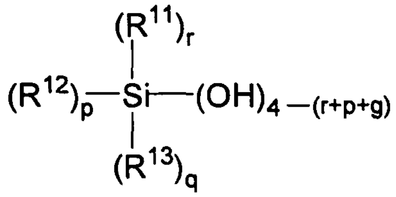

(2)

worin $R^{11}$, $R^{12}$ und $R^{13}$ gleich oder voneinander verschieden sein können und jeweils eine substituierte oder unsubstituierte Alkylgruppe mit 1 bis 30 Kohlenstoffatomen, eine substituierte oder unsubstituierte aromatische Gruppe mit 6 bis 30 Kohlenstoffatomen oder eine substituierte oder unsubstituierte, aromatische, heterocyclische Gruppe mit 3 bis 30 Kohlenstoffatomen sind; und p, q und r jeweils eine ganze Zahl von 0 bis 3 sind, unter der Voraussetzung, dass p + q + r 3 oder weniger ist;

$R^{14}$-Ar-OH (3)

worin $R^{14}$ eine substituierte oder unsubstituierte Alkylgruppe mit 1 bis 30 Kohlenstoffatomen oder eine substituierte oder unsubstituierte aromatische Gruppe mit 6 bis 30 Kohlenstoffatomen ist; und Ar eine substituierte oder unsubstituierte aromatische Gruppe mit 3 bis 30 Kohlenstoffatomen ist.

**4.** Holografisches Aufzeichnungsmedium gemäss Anspruch 1, **dadurch gekennzeichnet, dass** die Aufzeichnungsschicht ferner mindestens eine Art von Verbindungen der folgenden allgemeinen Formeln (4), (5) und (6) umfasst:

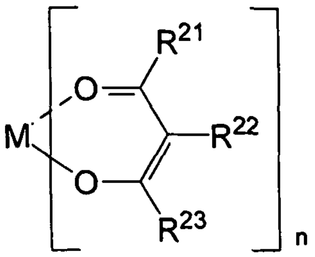

(4)

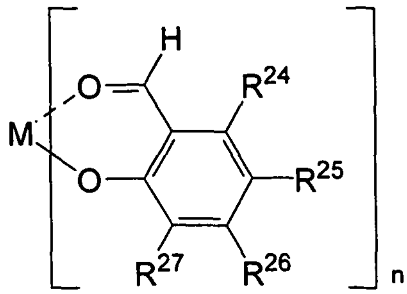

(5)

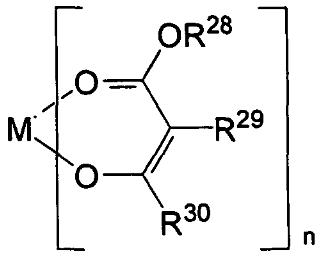

(6)

worin M aus der Gruppe bestehend aus Al, Ti, Cr, Mn, Fe, Co, Ni, Cu, Zr, Zn, Ba, Ca, Ce, Pb, Mg, Sn und V ausgewählt ist; $R^{21}$, $R^{22}$ und $R^{23}$ gleich oder voneinander verschieden sein können und jeweils ein Wasserstoffatom oder eine substituierte oder unsubstituierte Alkylgruppe mit 1 bis 10 Kohlenstoffatomen sind; $R^{24}$, $R^{25}$, $R^{26}$ und $R^{27}$ gleich oder voneinander verschieden sein können und jeweils ein Wasserstoffatom oder eine substituierte oder unsubstituierte Alkylgruppe mit 1 bis 10 Kohlenstoffatomen sind; $R^{28}$, $R^{29}$ und $R^{30}$ gleich oder voneinander verschieden sein können und jeweils ein Wasserstoffatom oder eine substituierte oder unsubstituierte Alkylgruppe mit 1 bis 10 Kohlenstoffatomen sind; und n eine ganze Zahl von 2 bis 4 ist.

5. Holografisches Aufzeichnungsmedium gemäss Anspruch 3, **dadurch gekennzeichnet, dass** die durch die allgemeine Formel (2) dargestellte Verbindung Diphenyldisilanol oder Triphenylsilanol ist.

6. Holografisches Aufzeichnungsmedium gemäss Anspruch 4, **dadurch gekennzeichnet, dass** M in den allgemeinen Formeln (4), (5) und (6) Al ist.

7. Holografisches Aufzeichnungsmedium gemäss Anspruch 4, **dadurch gekennzeichnet, dass** die Verbindung der allgemeinen Formel (4) ein Acetyl-Aceton-Komplex ist.

8. Holografisches Aufzeichnungsmedium gemäss Anspruch 4, **dadurch gekennzeichnet, dass** die Verbindung der allgemeinen Formel (6) ein Ethyl-Acetat-Komplex ist.

9. Holografisches Aufzeichnungsmedium gemäss Anspruch 1, **dadurch gekennzeichnet, dass** die radikalpolymerisierbare Verbindung Vinylcarbazol oder Vinylnaphthalin ist.

10. Holografisches Aufzeichnungsmedium gemäss Anspruch 4, **dadurch gekennzeichnet, dass** die Verbindung der allgemeinen Formel (2) Triphenylsilanol ist, die Verbindung der allgemeinen Formel (6) ein Aluminium-Ethylacetat-Komplex ist und die radikalpolymerisierbare Verbindung Vinylcarbazol oder Vinylnaphthalin ist.

11. Holografisches Aufzeichnungsmedium gemäss Anspruch 1, **dadurch gekennzeichnet, dass** die Aufzeichnungsschicht ferner eine Verbindung der folgenden allgemeinen Formel (7) umfasst:

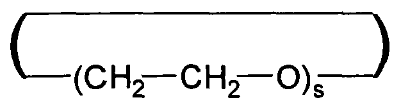

(7)

worin s eine ganze Zahl von 3 bis 30 ist.

12. Holografisches Aufzeichnungsmedium gemäss Anspruch 11, **dadurch gekennzeichnet, dass** s in der allgemeinen Formel (7) eine ganze Zahl von 3 bis 6 ist.

13. Holografisches Aufzeichnungsmedium gemäss Anspruch 1, **dadurch gekennzeichnet, dass** die Aufzeichnungsschicht ferner eine Verbindung der folgenden allgemeinen Formel (8) umfasst:

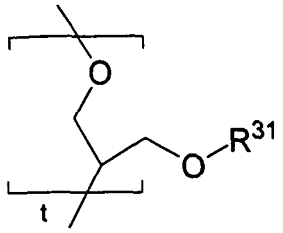

( 8 )

worin $R^{31}$ eine unsubstituierte Alkylgruppe mit 1 bis 12 Kohlenstoffatomen, eine Methoxyethylgruppe oder eine Methoxyethoxyethylgruppe ist.

**14.** Verfahren zur Herstellung eines holografischen Aufzeichnungsmediums, **dadurch gekennzeichnet, dass** es umfasst:

Mischen eines Epoxymonomers, eines Kohlenwasserstoffsubstituierten Silanols, eines Metallkomplexes, eines Fotoradikal-Polymerisationsinitiators und einer radikalpolymerisierbaren Verbindung, um eine Rohmateriallösung für eine Aufzeichnungsschicht zu erhalten;
Beschichten der Rohmateriallösung auf ein lichtdurchlässiges Substrat oder Einbringen der Rohmateriallösung zwischen einem Paar gegenüberliegender lichtdurchlässiger Substrate, um eine Harzschicht zu bilden; und
Erwärmen der Harzschicht bei einer Temperatur im Bereich von 10°C bis weniger als 80°C, um das Epoxymonomer zu polymerisieren, wodurch eine Aufzeichnungsschicht gebildet wird, die eine dreidimensional vernetzte Polymermatrix der folgenden allgemeinen Formel (1) umfasst:

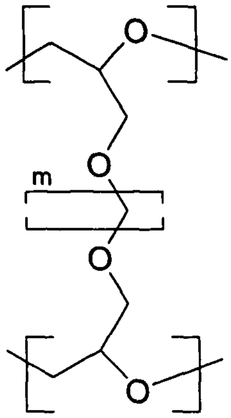

( 1 )

worin m eine ganze Zahl ist von 3 bis 16 ist.

**15.** Verfahren gemäss Anspruch 14, **dadurch gekennzeichnet, dass** das Epoxymonomer eine Verbindung der folgenden allgemeinen Formel (9) ist:

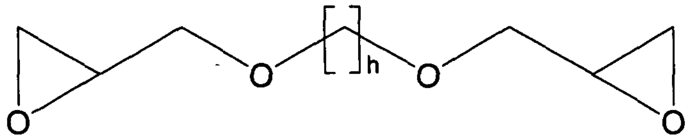

( 9 )

worin h eine ganze Zahl von 8 bis 12 ist.

**16.** Verfahren gemäss Anspruch 14, **dadurch gekennzeichnet, dass** das Kohlenwasserstoff-substituierte Silanol eine

Verbindung der folgenden allgemeinen Formel (2) ist:

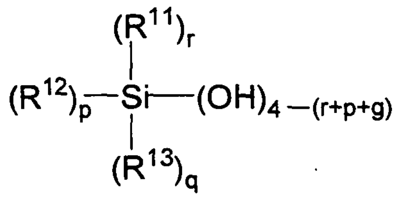

(2)

worin $R^{11}$, $R^{12}$ und $R^{13}$ gleich oder voneinander verschieden sein können und jeweils eine substituierte oder unsubstituierte Alkylgruppe mit 1 bis 30 Kohlenstoffatomen, eine substituierte oder unsubstituierte aromatische Gruppe mit 6 bis 30 Kohlenstoffatomen oder eine substituierte oder unsubstituierte, aromatische, heterocyclische Gruppe mit 3 bis 30 Kohlenstoffatomen sind; und p, q und r jeweils eine ganze Zahl von 0 bis 3 sind, unter der Voraussetzung, dass p + q + r 3 oder weniger ist.

**17.** Verfahren gemäss Anspruch 14, **dadurch gekennzeichnet, dass** der Metallkomplex eine Verbindung der folgenden allgemeinen Formel (4), (5) oder (6) ist:

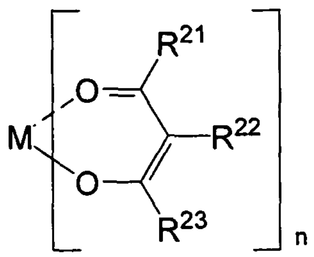

(4)

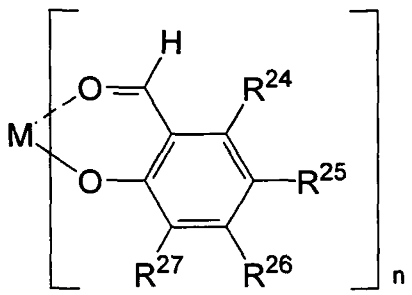

(5)

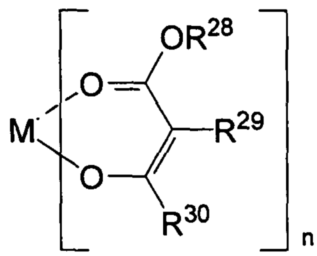

(6)

worin M aus der Gruppe bestehend aus Al, Ti, Cr, Mn, Fe, Co, Ni, Cu, Zr, Zn, Ba, Ca, Ce, Pb, Mg, Sn und V ausgewählt ist; $R^{21}$, $R^{22}$ und $R^{23}$ gleich oder voneinander verschieden sein können und jeweils ein Wasserstoffatom oder eine substituierte oder unsubstituierte Alkylgruppe mit 1 bis 10 Kohlenstoffatomen sind; $R^{24}$, $R^{25}$, $R^{26}$ und $R^{27}$ gleich oder voneinander verschieden sein können und jeweils ein Wasserstoffatom oder eine substituierte oder unsubstituierte Alkylgruppe mit 1 bis 10 Kohlenstoffatomen sind; $R^{28}$, $R^{29}$ und $R^{30}$ gleich oder voneinander verschieden sein können und jeweils ein Wasserstoffatom oder eine substituierte oder unsubstituierte Alkylgruppe mit 1 bis 10 Kohlenstoffatomen sind; und n eine ganze Zahl von 2 bis 4 ist.

**18.** Verfahren gemäss Anspruch 14, **dadurch gekennzeichnet, dass** der Fotoradikal-Polymerisationsinitiator aus der Gruppe bestehend aus Imidazolderivaten, organischen Azidverbindungen, Titanocenen, organischen Peroxiden, Thioxanthonderivaten und Oniumsalzen ausgewählt ist.

**19.** Verfahren gemäss Anspruch 14, **dadurch gekennzeichnet, dass** die radikalpolymerisierbare Verbindung aus der Gruppe bestehend aus Vinylverbindungen, Acrylverbindungen und Methacrylverbindungen ausgewählt ist.

**20.** Verfahren gemäss Anspruch 14, **dadurch gekennzeichnet, dass** die Harzschicht so ausgebildet ist, dass sie eine Dicke im Bereich von 0,1 bis 1,5 mm hat.

## Revendications

**1.** Support d'enregistrement holographique (12) comprenant une couche d'enregistrement (19) contenant :

une matrice polymère réticulante tridimensionnelle ;

un composé polymérisable par polymérisation radicalaire ; et
un initiateur de polymérisation photoradicalaire,

**caractérisé en ce que** la matrice polymère réticulante tridimensionnelle est représentée par la formule générale (1) suivante :

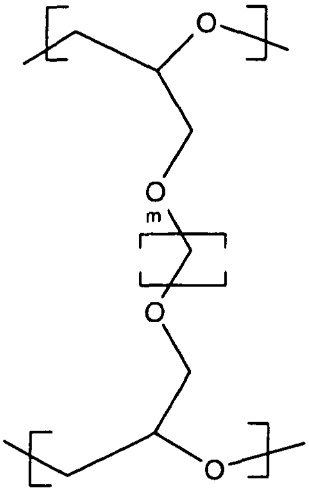

(1)

où m est un entier allant de 3 à 16.

2. Support d'enregistrement holographique selon la revendication 1, **caractérisé en ce que** m dans la formule générale (1) est un entier de 8 à 12.

3. Support d'enregistrement holographique selon la revendication 1, **caractérisé en ce que** la couche d'enregistrement comprend en outre au moins un composé choisi parmi un silanol substitué par un ou des groupes hydrocarbonés représenté par la formule générale (2) suivante et un composé phénolique représenté par la formule générale (3) suivante :

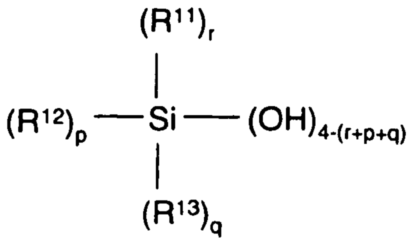

(2)

où $R^{11}$, $R^{12}$ et $R^{13}$ peuvent être identiques ou différents et sont individuellement un groupe alkyle substitué ou non substitué ayant 1 à 30 atomes de carbone, un groupe aromatique substitué ou non substitué ayant 6 à 30 atomes de carbone ou un groupe hétérocyclique aromatique substitué ou non substitué ayant 3 à 30 atomes de carbone ; et p, q et r sont individuellement un entier de 0 à 3, avec la condition que p+q+r soit 3 ou moins ;

$R^{14}$-Ar-OH (3)

où $R^{14}$ est un groupe alkyle substitué ou non substitué ayant 1 à 30 atomes de carbone ou un groupe aromatique substitué ayant 6 à 30 atomes de carbone ; et Ar est un groupe aromatique substitué ou non substitué ayant 3 à 30 atomes de carbone.

4. Support d'enregistrement holographique selon la revendication 1, **caractérisé en ce que** la couche d'enregistrement comprend en outre au moins un type de composés représentés par les formules générales (4), (5) et (6) suivantes :

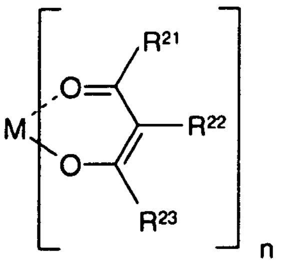

(4)

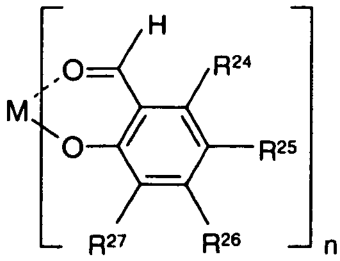

(5)

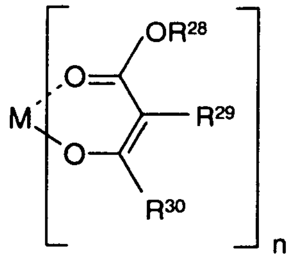

(6)

où M est choisi dans le groupe consistant en Al, Ti, Cr, Mn, Fe, Co, Ni, Cu, Zr, Zn, Ba, Ca, Ce, Pb, Mg, Sn et V ; $R^{21}$, $R^{22}$ et $R^{23}$ peuvent être identiques ou différents et sont individuellement un atome d'hydrogène, un groupe alkyle substitué ou non substitué ayant 1 à 10 atomes de carbone ; $R^{24}$, $R^{25}$ , $R^{26}$ et $R^{27}$ peuvent être identiques ou différents et sont individuellement un atome d'hydrogène, un groupe alkyle substitué ou non substitué ayant 1 à 10 atomes de carbone ; $R^{28}$, $R^{29}$ et $R^{30}$ peuvent être identiques ou différents et sont individuellement un atome d'hydrogène, un groupe alkyle substitué ou non substitué ayant 1 à 10 atomes de carbone ; et n est un entier de 2 à 4.

5. Support d'enregistrement holographique selon la revendication 3, **caractérisé en ce que** le composé représenté par la formule générale (2) est le diphényl disilanol ou le triphényl silanol.

6. Support d'enregistrement holographique selon la revendication 4, **caractérisé en ce que** le M dans les formules générales (4), (5) et (6) est Al.

7. Support d'enregistrement holographique selon la revendication 4, **caractérisé en ce que** le composé représenté par la formule générale (4) est un complexe d'acétylacétone.

8. Support d'enregistrement holographique selon la revendication 4, **caractérisé en ce que** le composé représenté par la formule générale (6) est un complexe d'acétate d'éthyle.

9. Support d'enregistrement holographique selon la revendication 1, **caractérisé en ce que** le composé polymérisable par polymérisation radicalaire est le vinylcarbazole ou le vinylnaphtalène.

10. Support d'enregistrement holographique selon la revendication 4, **caractérisé en ce que** le composé représenté par la formule générale (2) est le triphényl silanol, le composé représenté par la formule générale (6) est un complexe d'aluminium et d'acétate d'éthyle et le composé polymérisable par polymérisation radicalaire est le vinylcarbazole ou le vinylnaphtalène.

11. Support d'enregistrement holographique selon la revendication 1, **caractérisé en ce que** la couche d'enregistrement comprend en outre un composé représenté par la formule générale (7) suivante :

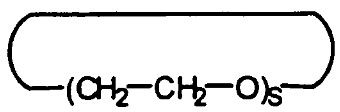

(7)

où s est un entier de 3 à 30.

12. Support d'enregistrement holographique selon la revendication 11, **caractérisé en ce que** s dans la formule générale (7) est un entier de 3 à 6.

13. Support d'enregistrement holographique selon la revendication 1, **caractérisé en ce que** la couche d'enregistrement comprend en outre un composé représenté par la formule générale (8) suivante :

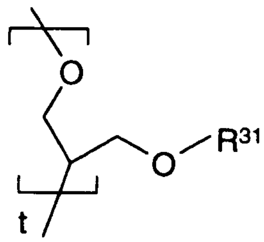

(8)

où $R^{31}$ est un groupe alkyle non substitué ayant 1 à 12 atomes de carbone, un groupe méthoxyéthyle ou un groupe méthoxyéthoxyéthyle.

**14.** Procédé de fabrication d'un support d'enregistrement holographique **caractérisé en ce qu'**il comprend :

le mélange d'un monomère époxy, d'un silanol substitué par un ou des groupes hydrocarbonés, d'un complexe métallique, d'un initiateur de polymérisation photoradicalaire et d'un composé polymérisable par polymérisation radicalaire pour obtenir une solution de produit brut pour une couche d'enregistrement ;
l'application en revêtement de la solution de produit brut sur un substrat transmettant la lumière ou l'interposition de la solution de produit brut entre deux substrats transmettant la lumière se faisant face pour former une couche de résine ; et
le chauffage de la couche de résine à une température dans une plage de 10°C à moins de 80°C pour polymériser le monomère époxy, en formant ainsi une couche d'enregistrement comprenant une matrice polymère réticulante tridimensionnelle représentée par la formule générale (1) suivante :

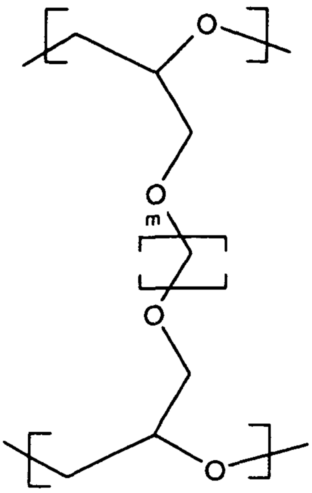

(1)

où m est un entier allant de 3 à 16.

**15.** Procédé selon la revendication 14, **caractérisé en ce que** le monomère époxy est un composé représenté par la formule générale (9) suivante :

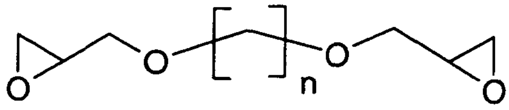

(9)

où h est un entier allant de 8 à 12.

**16.** Procédé selon la revendication 14, **caractérisé en ce que** le silanol substitué par un ou des groupes hydrocarbonés est un composé représenté par la formule générale (2) suivante :

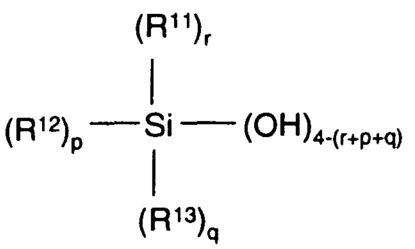

(2)

où $R^{11}$, $R^{12}$ et $R^{13}$ peuvent être identiques ou différents et sont individuellement un groupe alkyle substitué ou non substitué ayant 1 à 30 atomes de carbone, un groupe aromatique substitué ou non substitué ayant 6 à 30 atomes de carbone ou un groupe hétérocyclique aromatique substitué ou non substitué ayant 3 à 30 atomes de carbone ; et p, q et r sont individuellement un entier de 0 à 3 avec la condition que p+q+r soit 3 ou moins.

**17.** Procédé selon la revendication 14, **caractérisé en ce que** le complexe métallique est un composé représenté par les formules générales (4), (5) ou (6) suivantes :

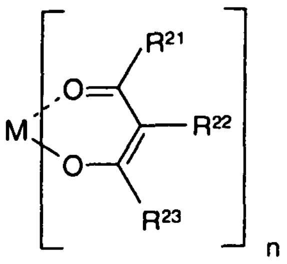

(4)

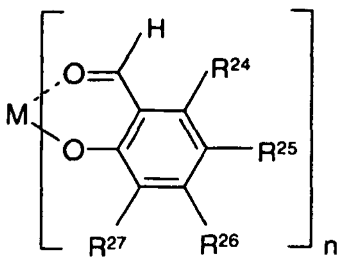

(5)

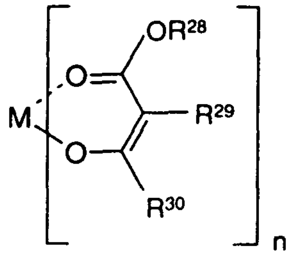

(6)

où M est choisi dans le groupe consistant en Al, Ti, Cr, Mn, Fe, Co, Ni, Cu, Zr, Zn, Ba, Ca, Ce, Pb, Mg, Sn et V ; $R^{21}$, $R^{22}$ et $R^{23}$ peuvent être identiques ou différents et sont individuellement un atome d'hydrogène, un groupe alkyle substitué ou non substitué ayant 1 à 10 atomes de carbone ; $R^{24}$, $R^{25}$, $R^{26}$ et $R^{27}$ peuvent être identiques ou différents et sont individuellement un atome d'hydrogène, un groupe alkyle substitué ou non substitué ayant 1 à 10 atomes de carbone ; $R^{18}$, $R^{29}$ et $R^{30}$ peuvent être identiques ou différents et sont individuellement un atome d'hydrogène, un groupe alkyle substitué ou non substitué ayant 1 à 10 atomes de carbone ; et n est un entier de 2 à 4.

**18.** Procédé selon la revendication 14, **caractérisé en ce que** l'initiateur de polymérisation photoradicalaire est choisi dans le groupe consistant en les dérivés de l'imidazole, les composés azides organiques, les titanocènes, les peroxydes organiques, les dérivés de thioxanthone et les sels d'onium.

**19.** Procédé selon la revendication 14, **caractérisé en ce que** le composé polymérisable par polymérisation radicalaire est choisi dans le groupe consistant en les composés vinyliques, les composés acryliques et les composés méthacryliques.

**20.** Procédé selon la revendication 14, **caractérisé en ce que** la couche de résine est formée pour avoir une épaisseur allant de 0,1 à 1,5 mm.

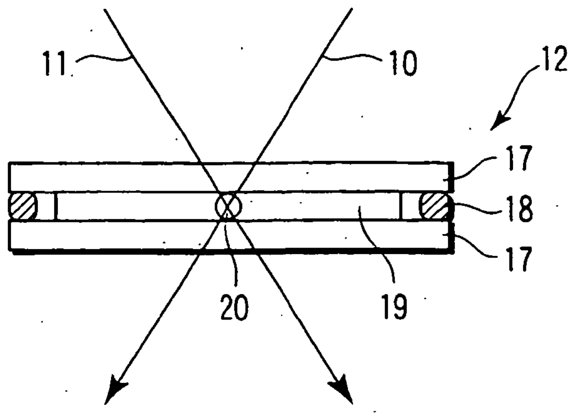


FIG.1

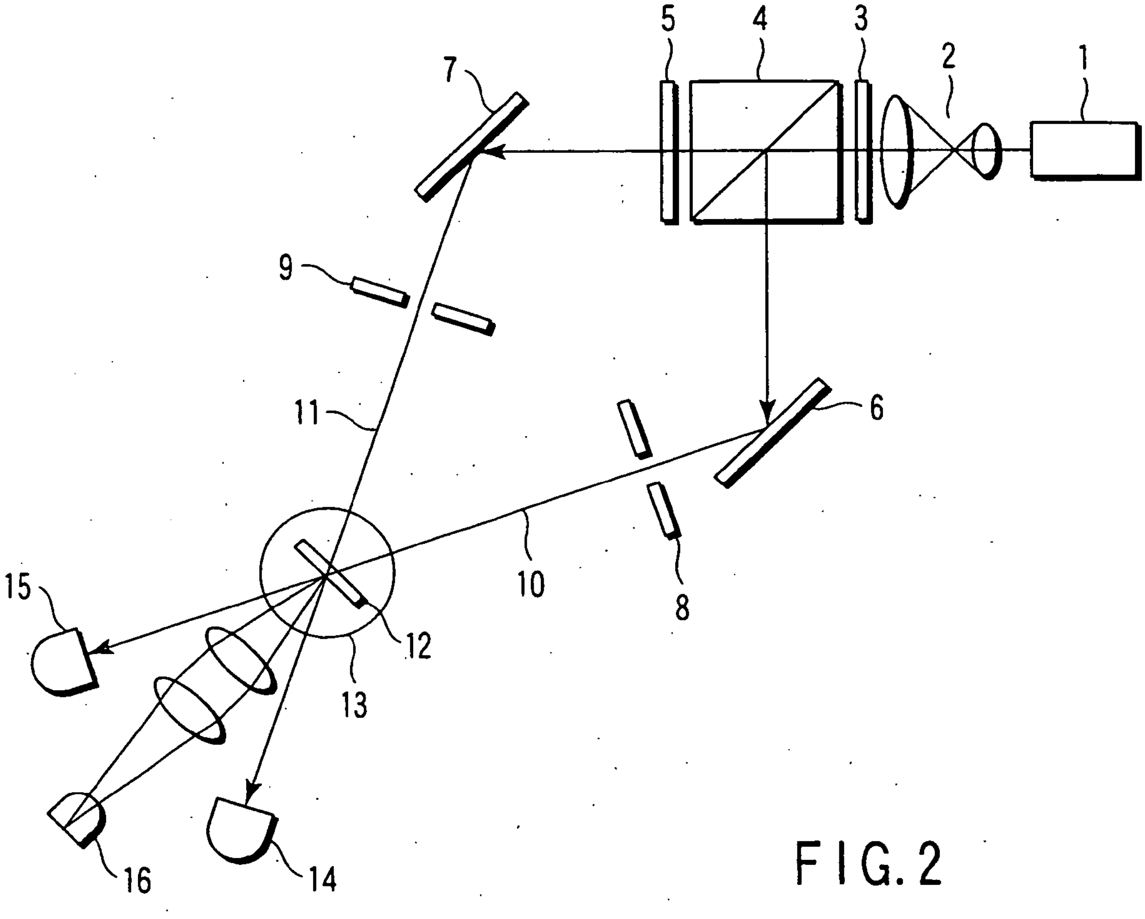


FIG.2

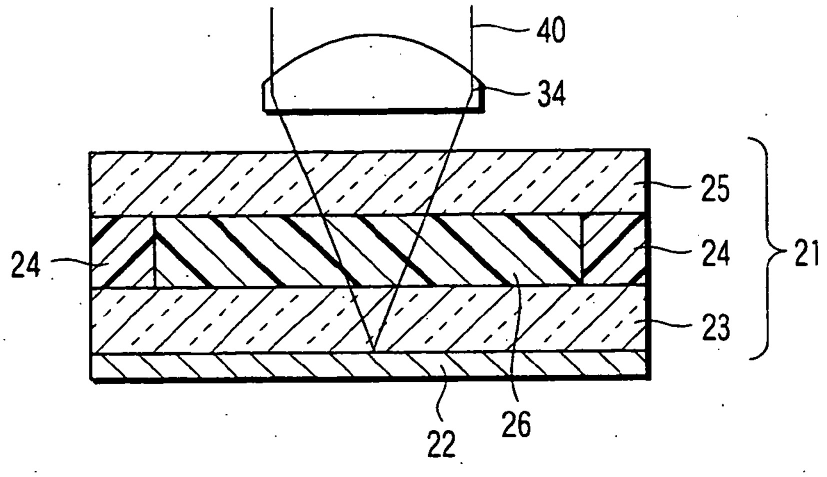


F I G. 3

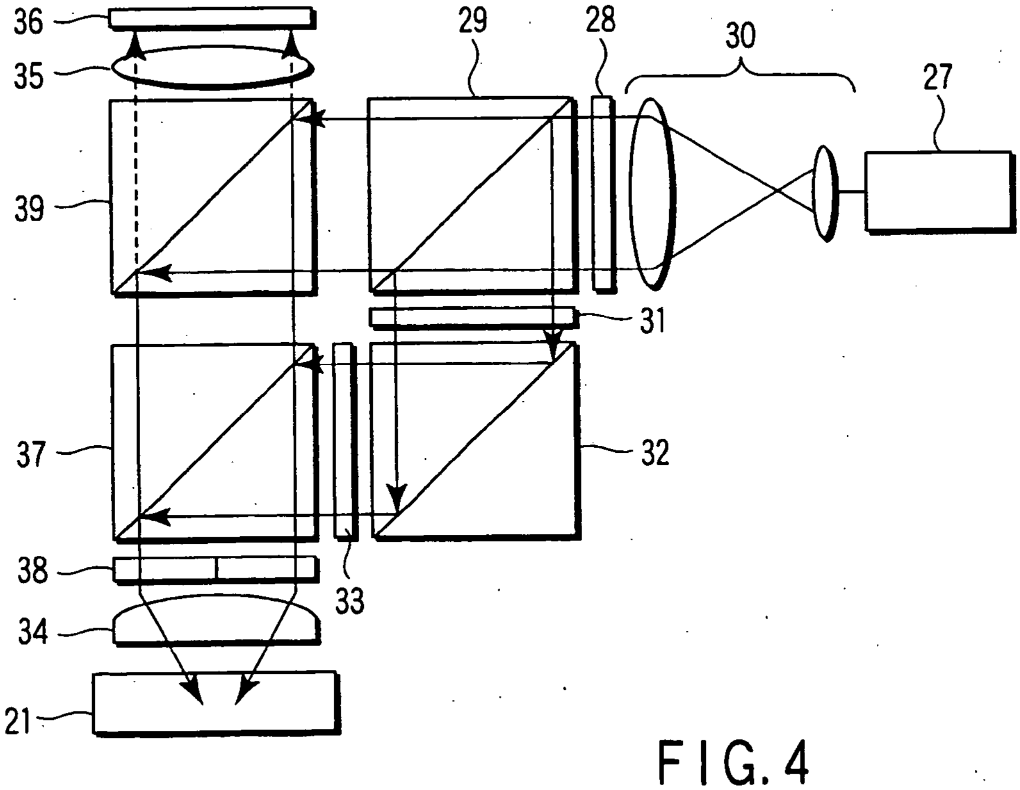


F I G. 4

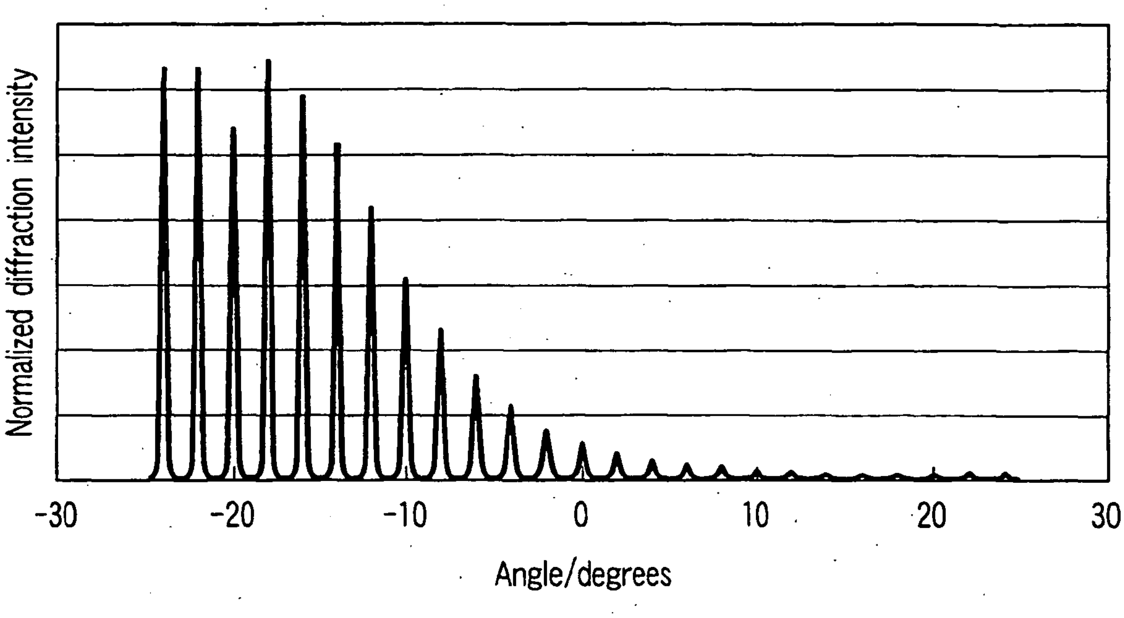
Normalized diffraction intensity
-30
-20
-10
0
10
20
30
Angle/degrees

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20060115740 A